# FASCICULE DE BREVET EUROPEEN

(11) **EP 4 015 445 B1**
(45) Date de publication et mention de la délivrance du brevet: **05.02.2025**
(21) Numéro de dépôt: 21215881.0
(22) Date de dépôt: 20.12.2021
(51) Int. Cl.: B81B 3/00

(54) **MICROSYSTÈME ÉLECTROMÉCANIQUE**
ELEKTROMECHANISCHES MIKROSYSTEM
ELECTROMECHANICAL MICROSYSTEM

(30) Priorité: 21.12.2020 FR 2013823
(43) Date de publication de la demande: 22.06.2022
(73) Titulaire: Commissariat à l'Energie Atomique et aux Energies Alternatives, 75015 Paris (FR)
(72) Inventeur: MOLLARD, Laurent, 38054 Grenoble Cedex 09 (FR); NICOLAS, Stéphane, 38054 Grenoble Cedex 09 (FR); SAINT-PATRICE, Damien, 38054 Grenoble Cedex 09 (FR)
(74) Mandataire: Hautier IP

(56) Documents cités:
- JP-A- H08 114 703
- US-A1- 2018 143 356
- US-A1- 2020 033 512

## Description

### DOMAINE TECHNIQUE

La présente invention concerne le domaine des microsystèmes électromécaniques. Elle trouve par exemple pour application particulièrement avantageuse l'actionnement ou le déplacement d'objets, y compris sur des distances relativement grandes. L'invention trouve également pour application le domaine de la détection par contact. Elle pourra ainsi être mise en oeuvre pour réaliser des capteurs.

### ÉTAT DE LA TECHNIQUE

Dans des applications variées, on peut avoir besoin de déplacer des objets microscopiques, voire nanoscopiques, et/ou avoir besoin de capter des mouvements de tels objets. Il existe des microsystèmes qui permettent cela.

Lorsque ces microsystèmes sont des actionneurs, leurs performances sont évaluées notamment sur les paramètres suivants: l'amplitude du déplacement, la force déployée et la précision du déplacement généré. Lorsque ces microsystèmes sont des capteurs, leurs performances sont évaluées notamment sur les paramètres suivants: la capacité à capter un mouvement sur une amplitude importante et la précision de la mesure.

Par ailleurs, que les microsystèmes soient des actionneurs ou des capteurs, on recherche à ce qu'ils offrent de bonnes performances en termes d'encombrement, de consommation énergétique et de capacité à travailler en fréquence.

Toutes les solutions connues présentent des performances faibles pour l'un au moins de ces paramètres. Généralement, les microsystèmes existants présentent des performances trop peu satisfaisantes pour une combinaison de ces paramètres.

Il est par ailleurs connu, du document de brevet US 2020/033512 A1, concerne généralement des modules optiques, et plus spécifiquement des modules optiques qui peuvent être utilisés dans des systèmes de caméras et des systèmes d'objectifs à haute résolution et à petit facteur de forme.

Ce document divulgue un objectif variable comprenant une membrane déformable formant le couvercle d'une cavité remplie d'un fluide incompressible où deux actionneurs sur la membrane modifient la courbure de la membrane pour changer la distance focale de l'objectif.

Le document de brevet JP H 08114703 A divulgue un objectif variable où la membrane principale étant actionnée à travers une cavité remplie de fluide par une membrane d'actionnement située dans le couvercle de la cavité et placée à distance de la membrane principale.

Un objet de la présente invention est de proposer un microsystème électromécanique qui présente des performances améliorées par rapport aux solutions existantes, au moins pour l'un des paramètres mentionnés ci-dessus, ou qui présente un meilleur compromis concernant au moins deux des paramètres susmentionnés.

Un autre objet de la présente invention est de proposer un microsystème électromécanique qui permet de déplacer vers le haut et vers le bas un organe externe qui lui est associé ou qui permet de capter un déplacement vers le haut et vers le bas d'un organe externe qui lui est associé.

Les autres objets, caractéristiques et avantages de la présente invention apparaîtront à l'examen de la description suivante et des dessins d'accompagnement.

Il est entendu que d'autres avantages peuvent être incorporés.

### RÉSUMÉ

Pour atteindre cet objectif on prévoit un microsystème électromécanique tel que défini dans la revendication 1.

La zone libre pouvant être configurée pour coopérer avec au moins un organe externe de sorte que sa déformation induise, ou soit induite par, un mouvement de l'organe externe, la solution proposée est ainsi apte à déplacer l'organe externe alternativement vers l'intérieur et vers l'extérieur de la cavité et/ou à capter un mouvement de cet organe alternativement vers l'intérieur et vers l'extérieur de la cavité.

Plus particulièrement, la solution proposée permet au microsystème électromécanique de déplacer l'organe externe vers l'intérieur de la cavité lorsque le premier transducteur est sollicité et vers l'extérieur de la cavité lorsque le deuxième transducteur est sollicité.

**En** alternative ou en complément, la solution proposée permet au microsystème électromécanique de capter un mouvement de l'organe externe vers l'intérieur de la cavité par la captation d'un courant électrique généré par le mouvement du premier transducteur vers l'extérieur de la cavité et un mouvement de l'organe externe vers l'extérieur de la cavité par la captation d'un courant électrique généré par le mouvement du deuxième transducteur vers l'intérieur de la cavité.

Par ailleurs, la solution proposée permet au microsystème électromécanique de former un actionneur dit à grand débattement, c'est-à-dire autorisant typiquement le déplacement de l'organe externe sur une longueur de course d'au moins 30 µm, voire de 100 µm (10⁻⁶ mètre). De même, la solution proposée permet au microsystème électromécanique de former un capteur dit à grand débattement, autorisant typiquement à capter un déplacement dont l'amplitude est d'au moins 30 µm, voire de 100 µm (10⁻⁶ mètre).

Le microsystème électromécanique tel qu'introduit ci-dessus est ainsi apte à déplacer l'organe externe ou à capter un mouvement de cet organe, et ce en présentant, de façon aisément modulable en fonction des applications visées, une capacité suffisante en termes d'amplitude de déplacement et/ou une capacité suffisante en termes de force déployée et/ou une capacité de captation de mouvement sur une amplitude suffisante et/ou une capacité suffisante à travailler en fréquence et/ou une taille compatible avec les applications visées, et/ou une consommation en énergie réduite.

De manière facultative, lesdits au moins deux transducteurs électromécaniques s'étendent, sur au moins une des parois de la cavité, à distance de la zone libre de la membrane déformable. En ce sens, lesdits au moins deux transducteurs électromécaniques sont disjoints de (ou ne sont pas adjacents à) la zone libre de la membrane déformable.

Un autre aspect de l'invention concerne un système ou un microsystème opto-électro-mécanique comprenant au moins un microsystème électromécanique tel qu'introduit ci-dessus et au moins un microsystème optique.

Un autre aspect de l'invention concerne un procédé de fabrication d'un microsystème électromécanique tel qu'introduit ci-dessus, comprenant, voire étant limité à, des étapes de dépôt et de gravure ordinaires en microélectronique. Le microsystème électromécanique peut en effet être fabriqué par des moyens ordinaires de la microélectronique, ce qui confère à son fabricant tous les avantages découlant de l'utilisation de ces moyens, dont une grande latitude en termes de dimensionnement, d'énergie d'adhésion entre les différents dépôts, d'épaisseur des différents dépôts, d'étendue de gravure, etc.

Un procédé de fabrication d'un microsystème électromécanique selon l'invention est défini dans la revendication 14.

### BRÈVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :
La figure 1A est un schéma de principe d'une vue en coupe ou d'une coupe d'un microsystème électromécanique comprenant deux transducteurs électromécaniques selon un premier mode de réalisation de l'invention.
La figure 1B est un schéma de principe d'une vue de haut du microsystème électromécanique selon le premier mode de réalisation de l'invention, un premier des deux transducteurs prenant la forme d'un disque, le second formant un anneau entourant le premier.
La figure 1C est un schéma de principe d'une vue en coupe d'un microsystème électromécanique selon un deuxième mode de réalisation de l'invention.
La figure 2 représente schématiquement une vue en coupe ou d'une coupe d'un microsystème électromécanique selon le premier mode de réalisation de l'invention.
La figure 3 représente schématiquement une vue en coupe ou d'une coupe du microsystème électromécanique selon le premier mode de réalisation de l'invention à une première étape de son procédé de fabrication.
Les figures 4 à 9 représentent schématiquement une vue en coupe ou d'une coupe du microsystème électromécanique selon le premier mode de réalisation de l'invention à différentes étapes de son procédé de fabrication.
La figure 10A représente schématiquement un premier mode de réalisation d'un microsystème opto-électro-mécanique comprenant quatre microsystèmes électromécaniques selon un mode de réalisation de l'invention.
La figure 10B représente schématiquement un deuxième mode de réalisation d'un microsystème opto-électro-mécanique comprenant quatre microsystèmes électromécaniques selon un mode de réalisation de l'invention.
Les figures 11A et 11B représentent chacune schématiquement d'autres modes de réalisation d'un microsystème opto-électro-mécanique comprenant quatre microsystèmes électromécaniques selon un mode de réalisation de l'invention.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier, les épaisseurs des différentes couches, parois et organes illustrés ne sont pas nécessairement représentatives de la réalité. De même, les dimensions latérales des éléments piézoélectriques, de la zone libre de la membrane et/ou des butées ne sont pas nécessairement représentatives de la réalité, notamment lorsque considérées l'une par rapport à une autre.

### DESCRIPTION DÉTAILLÉE

Avant d'entamer une revue détaillée de modes de réalisation de l'invention, sont énoncées ci-après des caractéristiques optionnelles qui peuvent éventuellement être utilisées en association ou alternativement.

Selon un exemple, ledit au moins un premier transducteur électromécanique comprend au moins un premier transducteur électromécanique ayant la forme d'un disque de rayon R1 et ledit au moins un deuxième transducteur électromécanique comprend au moins un deuxième transducteur électromécanique ayant la forme d'un anneau d'étendue radiale R2.

Selon l'exemple précédent, ledit au moins un premier transducteur électromécanique et ledit au moins un deuxième transducteur électromécanique s'inscrivent étroitement dans une zone circulaire de rayon déterminé appelé « rayon total » et noté Rₜₒₜ, ladite zone circulaire étant composée de deux parties, une première partie prenant la forme d'un disque centré sur ladite zone circulaire et une seconde partie prenant la forme d'un anneau s'étendant autour de la première partie. Ledit au moins un premier transducteur électromécanique s'inscrit plus particulièrement dans la première partie de la zone circulaire et ledit au moins un deuxième transducteur électromécanique s'inscrit plus particulièrement dans la seconde partie de la zone circulaire. La première partie de la zone circulaire présente un rayon R_{2/3} sensiblement égale aux deux tiers du rayon total et la seconde partie de la zone circulaire présente une étendue E_{1/3} sensiblement égale au tiers du rayon total.

Selon l'exemple précédent, ledit au moins un premier transducteur électromécanique comprend en outre au moins un premier transducteur électromécanique ayant la forme d'un anneau, chaque premier transducteur électromécanique ayant la forme d'un anneau s'étendant autour du premier transducteur électromécanique ayant la forme d'un disque et le cas échant autour d'un autre premier transducteur électromécanique ayant la forme d'un anneau. Ledit au moins un deuxième transducteur électromécanique comprend une pluralité de deuxièmes transducteurs électromécaniques ayant chacun la forme d'un anneau et étant agencés de façon adjacente et concentrique entre eux. De préférence, le rayon total Rₜₒₜ est inférieur à 900 µm, de préférence inférieure à 600 µm, et encore plus préférentiellement inférieure à 300 µm.

Selon un exemple, ledit au moins un premier transducteur électromécanique est constitué d'un premier transducteur électromécanique ayant la forme d'un disque de rayon R1 et ledit au moins un deuxième transducteur électromécanique est constitué d'un deuxième transducteur électromécanique ayant la forme d'un anneau d'étendue radiale R2.

Selon l'exemple précédent, l'étendue radiale R2 de l'anneau formé par le deuxième transducteur électromécanique est sensiblement deux fois plus petite que le rayon R1 du disque formé par le premier transducteur électromécanique.

En complément ou en alternative à la caractéristique ci-dessus, le rayon R1 du disque formé par le premier transducteur électromécanique est au maximum égal au 2/3 de la somme Rₜₒₜ du rayon R1 du disque formé par le premier transducteur électromécanique et de l'étendue radiale R2 de l'anneau formé par le deuxième transducteur électromécanique, et l'étendue radiale R2 de l'anneau formé par le deuxième transducteur électromécanique est au maximum égale à 1/3 de la somme Rₜₒₜ du rayon R1 du disque formé par le premier transducteur électromécanique et de l'étendue radiale R2 de l'anneau formé par le deuxième transducteur électromécanique.

De préférence, les transducteurs électromécaniques sont concentriques.

Selon un exemple, la zone libre est libre de se déformer, de préférence de façon élastique, en fonction dudit changement de pression externe.

Le microsystème électromécanique tel qu'introduit ci-dessus est de préférence exempt d'élément optique, telle qu'une lentille, notamment à focale variable.

Selon un exemple, le pion est fixé sur ladite zone libre, au contact de ladite zone libre, et plus précisément au contact d'une face externe de la zone libre.

Selon l'exemple précédent, le pion peut être fixé au centre de la zone libre de la membrane déformable. De la sorte, l'on s'assure que le mouvement du pion est un mouvement de translation perpendiculaire au plan dans lequel s'inscrit la paroi de la cavité qui est en partie formée par la membrane déformable, lorsque la membrane n'est pas déformée.

Le pion peut être configuré pour coopérer avec l'organe externe par l'intermédiaire d'un guide solidaire de l'organe externe, de sorte à permettre un positionnement automatique de l'organe externe sur le pion.

Le pion peut être configuré pour pouvoir être solidarisé avec l'organe externe par collage ou magnétisme, l'énergie d'adhérence du pion sur la zone libre de la membrane déformable étant de préférence supérieure à celle du pion sur l'organe externe. Une solidarisation, éventuellement amovible, du pion et de l'organe externe est ainsi prévue qui est largement modulable en termes de force de retenue.

Selon un exemple, au moins une partie desdits au moins deux transducteurs électromécaniques forme une partie de la paroi de la cavité qui est en partie formée par la membrane déformable. Le microsystème électromécanique selon cette caractéristique présente une structure non-traversante, laissant libre les autres parois de la cavité de sorte à pouvoir y réaliser d'autres fonctions ou de sorte à leur permettre de rester inertes, pour une capacité d'intégration accrue notamment dans un microsystème opto-électro-mécanique.

Selon un exemple, lesdits au moins deux transducteurs électromécaniques s'étendent, directement ou indirectement, sur la membrane déformable.

Ledit au moins un deuxième transducteur électromécanique peut être configuré de sorte qu'un mouvement de sa partie mobile de sa position d'équilibre à sa position hors équilibre induise un accroissement de la pression externe agissant sur le milieu déformable et la membrane déformable peut être configurée de sorte qu'un accroissement de la pression externe agissant sur le milieu déformable induise une déformation de la zone libre de la membrane déformable tendant à l'éloigner du centre de la cavité (plus précisément à l'éloigner d'une paroi fixe de la cavité telle que la paroi opposée à la paroi formée en partie par la membrane). Le microsystème électromécanique est ainsi configuré de sorte à induire un déplacement de l'organe externe dans un premier sens, correspondant à un éloignement de l'organe externe par rapport à la cavité (plus précisément à l'éloigner d'une paroi fixe de la cavité telle que la paroi opposée à la paroi formée en partie par la membrane).

En complément à la caractéristique précédente, ledit au moins premier transducteur électromécanique peut être configuré de sorte qu'un mouvement de sa partie mobile de sa position d'équilibre à sa position hors équilibre induise une diminution de la pression externe agissant sur le milieu déformable et la membrane déformable peut être configurée de sorte qu'une diminution de la pression externe agissant sur le milieu déformable induise une déformation de la zone libre de la membrane déformable tendant à la rapprocher du centre de la cavité (plus précisément à la rapprocher d'une paroi fixe de la cavité telle que la paroi opposée à la paroi formée en partie par la membrane). Le microsystème électromécanique est ainsi configuré en outre de sorte à induire un déplacement de l'organe externe dans un deuxième sens, ce deuxième sens tendant à rapprocher l'organe externe de la cavité (plus précisément à le rapprocher d'une paroi fixe de la cavité telle que la paroi opposée à la paroi formée en partie par la membrane).

La membrane déformable est de préférence configurée de sorte que sa zone libre soit capable de se déformer avec une amplitude d'au moins 50 µm, voire d'au moins 100 µm, voire d'au moins 1000 µm, selon une direction perpendiculaire au plan dans lequel elle s'étend principalement lorsqu'elle est au repos. Sans se déchirer et/ou sans usure significative, le microsystème électromécanique offre ainsi la capacité à satisfaire de nombreuses et diverses applications nécessitant un grand débattement, ce dernier étant défini le cas échéant par domaine technique concerné.

La partie mobile de chaque transducteur électromécanique peut présenter une surface au moins deux fois supérieure à une surface de la zone libre de la membrane déformable. De préférence, la surface des parties mobiles des transducteurs est au moins 5 fois, voire 10 fois, voire 20 fois supérieure à la surface de la zone libre 121 de la membrane déformable, voire à la surface des zones libres de la membrane déformable.

Chaque transducteur électromécanique peut être un transducteur piézoélectrique, de préférence comprenant un matériau piézoélectrique à base de PZT.

L'un au moins parmi lesdits au moins deux transducteurs électromécaniques peut être un transducteur à fonctionnement statique. En alternative ou en complément, **l'un au moins** parmi lesdits au moins deux transducteurs électromécaniques peut être un transducteur à fonctionnement vibratoire à au moins une fréquence de résonance, ladite au moins une fréquence de résonance étant de préférence inférieure à 100 kHz, et encore plus préférentiellement inférieure à 1 kHz.

Le milieu déformable contenu hermétiquement dans la cavité peut comprendre au moins un fluide, de préférence liquide. Le fluide présente de préférence une viscosité de l'ordre de 100 cSt (1cSt = 10-6 m2/s) à température et pression ambiantes.

Selon un exemple de réalisation non limitatif, le fluide présente une compressibilité comprise entre 10⁻⁹ et 10⁻¹⁰ Pa⁻¹ à 20°C, par exemple de l'ordre de 10⁻¹⁰ Pa⁻¹ à 20°C, sans que ces valeurs ne soient limitatives.

Le microsystème électromécanique peut comprendre en outre au moins une butée latérale configurée pour :
- guider le mouvement d'un organe externe, lorsque la zone libre est configurée pour coopérer avec ledit organe externe de sorte que sa déformation induise, ou soit induite par, un mouvement de l'organe externe, et/ou
- pour mettre en prise une partie non mobile d'un des transducteurs électromécaniques.

Ladite au moins une butée latérale peut être supportée par la paroi de la cavité qui est en partie formée par la membrane déformable. Selon un exemple optionnel, ladite butée latérale s'étend à l'opposé de la cavité.

**Il** est ainsi possible de :
- limiter, de manière contrôlée, fiable et reproductible, l'inclinaison de l'organe externe lors du mouvement de la partie mobile de chaque transducteur électromécanique, et/ou
- permettre un auto-positionnement de l'organe externe relativement à la zone libre de la membrane déformable, et/ou
- protéger la membrane déformable, et plus particulièrement sa zone libre, notamment d'un éventuel arrachement, lors d'un report ou d'un collage de l'organe externe.

Lorsque la zone libre de la membrane déformable est configurée pour coopérer avec l'organe externe via un pion, ce dernier peut présenter les caractéristiques optionnelles suivantes qui peuvent éventuellement être utilisées en association ou alternativement.

Le pion peut s'étendre depuis la zone libre de la membrane déformable au-delà de ladite au moins une butée latérale.

En alternative, le pion peut s'étendre depuis la zone libre de la membrane déformable en-deçà de ladite au moins une butée latérale.

Le microsystème électromécanique selon l'une ou l'autre de ces deux dernières caractéristiques offre une capacité d'adaptation satisfaisante à une large variété d'organes externes et d'applications.

Le microsystème électromécanique peut comprendre en outre une butée dite basse supportée par la paroi de la cavité opposée à la zone libre de la membrane déformable, ladite butée basse s'étendant dans la cavité vers la zone libre. Elle présente une forme et des dimensions configurées pour limiter la déformation de la zone libre de la membrane déformable de sorte à protéger la membrane déformable, et plus particulièrement sa zone libre, notamment d'un éventuel arrachement, en particulier lors d'un report ou d'un collage de l'organe externe. Par ailleurs, la butée dite basse peut être conformée pour limiter la surface de contact entre la membrane et la paroi de la cavité opposée à la zone libre de la membrane déformable. De manière alternative ou cumulée, la butée basse peut être conformée de sorte à limiter la surface de contact entre la membrane et la paroi de la cavité opposée à la zone libre de la membrane déformable. Cela permet d'éviter que la membrane n'adhère à cette paroi.

Le microsystème électromécanique tel qu'introduit ci-dessus peut comprendre en outre une pluralité de membranes déformables et/ou une pluralité de zones libres par membrane déformable.

Ledit au moins un microsystème optique du système opto-électro-mécanique tel qu'introduit ci-dessus peut comprendre au moins un miroir également désigné micro-miroir, de préférence à base de silicium.

Selon un exemple, le système opto-électro-mécanique est configuré de sorte à ce que le mouvement de la partie mobile de chacun desdits au moins deux transducteurs électromécaniques provoque un déplacement de l'au moins un miroir.

En alternative ou en complément, le système opto-électro-mécanique peut comprendre une pluralité de microsystèmes électromécaniques présentant chacun une zone libre agencée en vis-à-vis d'une partie d'un même microsystème optique, tel qu'un miroir. De préférence, le microsystème électromécanique coopère avec le miroir au niveau d'une zone qui n'est pas au centre du miroir mais par exemple dans un coin du miroir. On obtient ainsi un système ou un microsystème opto-électro-mécanique bénéficiant d'une large capacité d'adaptation de son orientation optique. Chaque **microsystème** électromécanique permettant de déplacer, alternativement vers l'intérieur et vers l'extérieur de la cavité, la partie du microsystème optique en vis-à-vis de laquelle il est agencé, un doublement de l'amplitude de mouvement du microsystème optique peut être atteint relativement à microsystème électromécanique ne permettant qu'un déplacement vers l'intérieur de la cavité ou vers l'extérieur de la cavité.

On entend, par « microsystème électromécanique », un système comprenant au moins un élément mécanique et au moins un transducteur électromécanique réalisés à l'échelle micrométrique avec des moyens de la microélectronique. L'élément mécanique peut être mis en mouvement (actionné) grâce à une force générée par le transducteur électromécanique. Ce dernier peut être alimenté par des tensions électriques produites avec des circuits électroniques avoisinants. En alternative ou en complément, le transducteur électromécanique peut capter un mouvement de l'élément mécanique ; le microsystème électromécanique joue alors le rôle de capteur.

Un « microsystème » est un système dont les dimensions externes sont inférieures à 1 centimètre (10⁻² mètres) et de préférence à 1 millimètre (10⁻³ mètres).

Le plus souvent, un transducteur électromécanique joue un rôle d'interface entre les domaines mécanique et électrique. Toutefois, on entend ici, par « transducteur électromécanique », aussi bien un transducteur piézoélectrique qu'un transducteur thermique, ce dernier jouant un rôle d'interface entre les domaines mécanique et thermique. Un transducteur électromécanique peut comprendre une partie mobile entre une position d'équilibre, hors sollicitation, et une position hors équilibre, sous sollicitation. Lorsque le transducteur est piézoélectrique, la sollicitation est de nature électrique. Lorsque le transducteur est thermique, la sollicitation est de nature thermique.

Lorsqu'il est fait mention du centre de la cavité, ce centre est défini géométriquement en considérant comme le centre d'une cavité présentant une zone libre non déformée de la membrane déformable.

On entend par « inférieur » et « supérieur », « inférieur ou égal » et supérieur ou égal », respectivement. L'égalité est exclue par l'usage des termes « strictement inférieur » et « strictement supérieur ».

On entend par un paramètre « sensiblement égal/supérieur/inférieur à » une valeur donnée que ce paramètre est égal/supérieur/inférieur à la valeur donnée, à plus ou moins 20 %, voire 10 %, près de cette valeur. On entend par un paramètre « sensiblement compris entre » deux valeurs données que ce paramètre est au minimum égal à la plus petite valeur donnée, à plus ou moins 20 %, voire 10 %, près de cette valeur, et au maximum égal à la plus grande valeur donnée, à plus ou moins 20 %, voire 10 %, près de cette valeur.

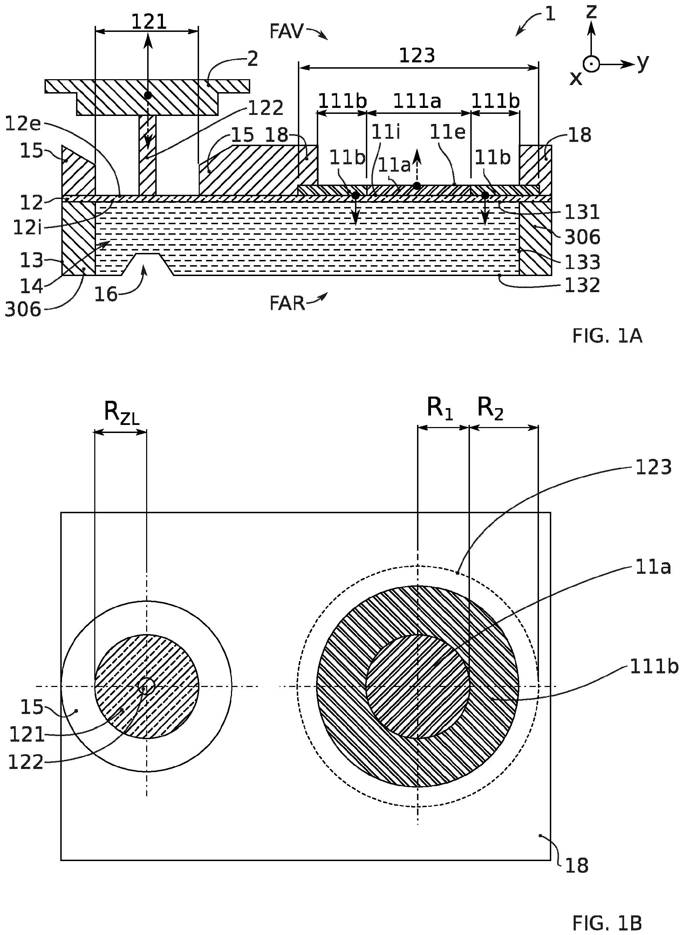

La figure 1A est un schéma de principe d'une vue en coupe ou d'une coupe d'un microsystème électromécanique 1 selon un premier mode de réalisation de l'invention. Sur la figure 1A, sont illustrés deux transducteurs électromécaniques 11a et 11b, une membrane déformable 12 et une cavité 13 configurée pour contenir hermétiquement un milieu déformable 14.

Ce schéma de principe peut aussi bien représenter une structure sans symétrie de rotation ou de révolution autour d'un axe perpendiculaire et centré par rapport à la surface de la membrane déformable telle qu'illustrée, qu'une structure s'étendant, par exemple de façon sensiblement invariante, perpendiculairement à la vue en coupe illustrée et symétrique pour une première partie par rapport à un plan perpendiculaire et centré par rapport à la zone référencée 121 et pour une deuxième partie par rapport à un plan perpendiculaire et centré par rapport à la zone référencée 111a.

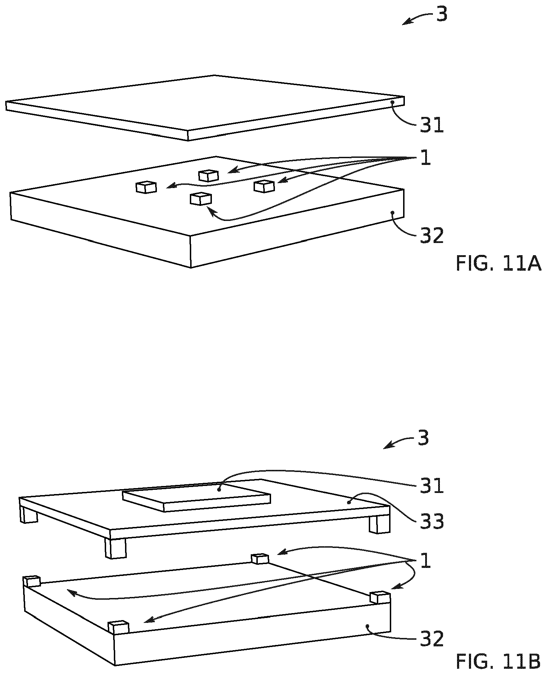

Avant de décrire plus avant les différents modes de réalisation de l'invention illustrés sur les figures annexées, notons que chacune de ces illustrations représente schématiquement un mode de réalisation du microsystème électromécanique selon l'invention qui présente une structure non traversante. Plus particulièrement, dans les différents modes illustrés, chaque transducteur électromécanique 11a et 11b et la membrane déformable 12 se situent tous deux en face avant FAV du microsystème électromécanique 1. Ce type de structure est particulièrement avantageux dans la mesure où la face arrière FAR du microsystème électromécanique 1 peut participer uniquement de façon passive, et en particulier sans se déformer, à la fonction d'actionneur et/ou de capteur du microsystème électromécanique 1. Plus particulièrement, la face arrière FAR d'un microsystème 1 à structure non traversante selon l'invention peut notamment constituer une face par laquelle le microsystème électromécanique 1 peut être aisément monté sur un support (référencé 32 sur les figures 11A et 11B) et/ou peut constituer une face par laquelle le microsystème peut aisément être davantage fonctionnalisé.

Toutefois, l'invention n'est pas limitée aux microsystèmes électromécaniques à structure non traversante. Dans son acceptation la plus large, l'invention concerne également des microsystèmes 1 dits à structure traversante dans lesquels au moins un des transducteurs 11a et 11b et la membrane déformable 12 sont agencés sur des parois distinctes entre elles de la cavité 13, que ces parois soient adjacentes ou opposées entre elles.

Chaque transducteur électromécanique 11a, 11b tel qu'illustré sur les figures 1A et 1B comprend au moins une partie mobile 111a, 111b. Cette dernière est configurée pour se mouvoir ou être mue entre au moins deux positions. Une première de ces positions est une position d'équilibre atteinte et conservée lorsque le transducteur 11a, 11b n'est pas sollicité, que ce soit par exemple par une tension électrique l'alimentant ou par une force le contraignant hors de sa position d'équilibre. Une deuxième position de la partie mobile 111a, 111b de chacun des deux transducteurs 11a, 11b est atteinte lorsque le transducteur est sollicité, que ce soit par exemple par une tension électrique l'alimentant ou par une force le contraignant hors de sa position d'équilibre. Chaque transducteur électromécanique 11a, 11b peut être maintenu dans l'une ou l'autre des première et deuxième positions décrites ci-dessus, et présenter ainsi un comportement binaire, ou être maintenu dans n'importe quelle position intermédiaire entre sa position d'équilibre et sa position de plus grande déformation, ou de plus grande déflexion, par rapport à l'équilibre.

Dans l'exemple illustré sur les figures 1A et 1B, lorsqu'un transducteur électromécanique 11a, 11b n'est pas sollicité, sa partie mobile 111a, 111b s'étend principalement dans un plan parallèle au plan xy du repère orthogonal xyz illustré en figure 1A.

Au moins un, de préférence chaque, transducteur électromécanique 11a, 11b est de préférence un transducteur piézoélectrique. De façon connue, un tel transducteur convertit une énergie électrique d'alimentation en un mouvement de sa partie mobile 111a, 111b de sa position d'équilibre à une position hors équilibre et/ou convertit un mouvement de sa partie mobile 111a, 111b, de sa position d'équilibre à une position hors équilibre, en un signal électrique. Il ressort donc de cet exemple, mais cela reste potentiellement vrai pour chacun des autres modes de réalisation envisagés du microsystème électromécanique 1 selon l'invention, que ce dernier peut fonctionner comme actionneur et/ou comme capteur. **En** tant qu'actionneur, il peut permettre de déplacer un organe externe 2 vers le haut et vers le bas, comme illustré sur la figure 1A. **En** tant que capteur, il peut permettre de capter un déplacement, en particulier un déplacement vertical, de l'organe externe 2 vers le haut et vers le bas, comme également illustré sur la figure 1A. De sorte que le signal généré puisse être fonction du déplacement de l'organe externe 2, et en particulier de son amplitude de déplacement, il est préférable que la surface de la zone libre 121 soit supérieure à la surface des parties mobiles 111a, 111b des transducteurs électromécaniques 11a, 11b qui est en contact avec la membrane déformable 12. Ci-dessous, pour des raisons de simplicité, nous décrivons essentiellement le microsystème électromécanique 1 comme un actionneur, sans toutefois exclure sa capacité à assurer, en alternative ou en complément, une fonction de capteur.

Au moins un, voire chaque, transducteur électromécanique 11a, 11b est encore plus préférentiellement un transducteur piézoélectrique comprenant un matériau piézoélectrique à base de PZT (Titano-Zirconate de Plomb). Dans ce cas, la partie mobile 111a, 111b du transducteur 11a, 11b est capable de se mouvoir avec un déplacement plus significatif (du fait du coefficient piézoélectrique d31) qu'avec bon nombre d'autres matériaux piézoélectriques. Toutefois, le PZT étant un matériau ferroélectrique, de tels transducteurs piézoélectriques fonctionnent chacun préférentiellement dans un seul sens d'actionnement (mouvement dans un unique sens de leur partie mobile 111a, 111b) quelle que soit la polarité de son alimentation électrique, alors qu'un transducteur piézoélectrique à base d'un matériau non-ferroélectrique peut préférentiellement fonctionner dans les deux sens (mouvement dans deux sens opposés de leur partie mobile 111a, 111b). En alternative ou en complément, au moins l'un, voire chaque, transducteur électromécanique 11a, 11b peut être un transducteur piézoélectrique (non ferroélectrique) à base d'un matériau propre à permettre à sa partie mobile 111a, 111b de se mouvoir dans des sens opposés relativement à sa position d'équilibre en fonction de la polarité de son alimentation électrique. Un tel matériau est par exemple un matériau à base de nitrure d'aluminium (AIN).

En alternative ou en complément, au moins un, voire chaque, transducteur électromécanique 11a, 11b peut être ou comprendre un transducteur thermique.

La membrane déformable 12 peut être à base d'un polymère, et est de préférence à base de PDMS (pour polydiméthylsiloxane). Les propriétés de la membrane déformable 12 en particulier son épaisseur, sa surface et sa forme peuvent être configurées pour conférer à la membrane déformable 12, et plus particulièrement à une zone 121 de cette membrane qui est libre de se déformer, une capacité d'étirement escomptée, notamment en fonction de l'application visée.

La cavité 13 telle qu'illustrée notamment sur la figure 1A présente plus particulièrement des parois 131, 132, 133 contenant hermétiquement le milieu déformable 14. Dans les exemples illustrés, la paroi 132 de la cavité 13 constitue la face arrière FAR du microsystème électromécanique 1. La paroi 131 opposée à la paroi 132 est formée au moins en partie par au moins une partie de la membrane déformable 12. Ainsi, la paroi 131 est déformable. La paroi 131 est désignée par la suite première paroi. Elle se situe au niveau de la face avant FAV du microsystème électromécanique 1. Au moins une paroi 133 latérale joint entre elles les parois 131 et 132. Cette paroi 133 latérale peut comprendre ou être constituée d'au moins un espaceur 306 tel qu'illustré sur la figure 1A et dont le rôle est détaillé plus bas. On notera que l'herméticité de la cavité 13 nécessite que la membrane déformable 12 soit elle-même imperméable, ou rendue imperméable, notamment au niveau de sa zone libre 121.

On notera également que, pour assurer plus aisément l'herméticité de la cavité 13 :
- la première paroi 131 de la cavité est de préférence entièrement formée ou recouverte par au moins la membrane déformable 12 et/ou
- chaque transducteur électromécanique 11a et 11b s'étend de toute son étendue sur la membrane déformable 12, en étant au contact, direct ou indirect, de celle-ci.

De préférence, les parois 132, 133 restent fixes lorsque la membrane se déforme.

Le milieu déformable 14 est quant à lui propre à conserver un volume sensiblement constant sous l'action d'un changement de pression externe. Autrement dit, il peut s'agir d'un milieu incompressible ou faiblement compressible dont la déformation nécessite de préférence peu d'énergie. Il s'agit par exemple d'un liquide.

Du fait qu'une partie au moins de la paroi 131 de la cavité 13 est formée par une partie au moins de la membrane déformable 12, l'on comprend que tout changement de pression externe exercée sur le milieu déformable 14 peut être compensé par une déformation, sensiblement proportionnelle, de la membrane déformable 12, et plus particulièrement de sa zone libre 121, et/ou par un déplacement de la partie mobile 111a, 111b d'un des transducteurs électromécaniques 11a, 11b. Lorsque l'un des transducteurs 11a, 11b est sollicité, cette compensation est plus particulièrement liée à une conversion du changement de pression externe exercée sur le milieu déformable 14 en un étirement de la membrane déformable 12. L'on comprend que, dans un souci de reproductibilité de l'actionnement ou de la captation de mouvement qu'offre le microsystème électromécanique 1 selon l'invention, il est préférable que toute déformation de la membrane déformable 12 soit élastique, et non plastique, pour garantir le retour dans un même état de moindre étirement, ou de relaxation maximale, de la membrane déformable 12 chaque fois qu'elle n'est plus contrainte.

Le milieu déformable 14 peut plus particulièrement comprendre au moins un fluide, de préférence liquide. Les paramètres du liquide seront adaptés en fonction des applications visés. L'on s'assure ainsi que tout changement de pression externe exercée sur le milieu déformable 14 induit une déformation sensiblement proportionnelle de la zone libre 121 de la membrane déformable 12. Le fluide peut être constitué ou à base d'un liquide, tel que de l'huile, ou peut être constitué ou à base d'un polymère. Selon un exemple, le fluide est à base ou est constituée de glycérine. L'on s'assure ainsi, en plus d'une déformation sensiblement proportionnelle de la membrane 12, de la capacité du milieu déformable 14 à occuper notamment le volume créé par étirement de la zone libre 121 de la membrane déformable 12 à l'opposé du centre de la cavité 13.

L'on comprend de ce qui précède que le microsystème électromécanique 1 est configuré de sorte que chaque mouvement d'un transducteur électromécanique 11a, 11b induise un changement de pression externe exercée sur le milieu déformable 14, pour réaliser la fonction d'actionneur du microsystème électromécanique 1, et inversement, pour réaliser la fonction de capteur du microsystème électromécanique 1. Plus particulièrement, lorsque le microsystème électromécanique 1 joue le rôle d'actionneur, au moins une partie d'un des transducteurs électromécaniques 11a et 11b est sollicité de sorte à exercer un changement de pression externe sur le milieu déformable 14 et induire par-là la déformation de la membrane déformable 12. Inversement, lorsque le microsystème électromécanique 1 joue le rôle de capteur, la déformation de la membrane 12 exerce un changement de pression externe sur le milieu déformable 14 qui induit un déplacement de la partie mobile 111a, 111b d'un des transducteurs électromécaniques 11a, 11b.

Comme illustré sur la figure 1A, le microsystème électromécanique 1 peut être tel que la zone libre 121 de la membrane déformable 12 est configurée pour coopérer avec un organe externe 2. De la sorte, la déformation de la zone libre 121 induit, ou est induite par, un mouvement de l'organe externe 2. C'est donc par l'intermédiaire de la zone libre 121 de la membrane déformable 12 que le microsystème 1 déplace l'organe externe 2 ou capte un mouvement de l'organe externe 2. Ainsi, lorsque le microsystème 1 joue le rôle d'actionneur, l'activation d'un des transducteurs électromécaniques 11a, 11b déforme la membrane 12 ce qui déplace l'organe 2. Inversement, lorsque le microsystème 1 joue le rôle de capteur, un appui d'un organe externe 2 sur la membrane 12 ou une traction de la membrane 12 par un organe externe 2 déforme la membrane 12, ce qui déplace l'une des parties mobiles des **transducteurs** électromécaniques 11a, 11b puis génère in fine un signal qui peut être fonction de ce déplacement.

Plus particulièrement, la coopération entre la zone libre 121 de la membrane déformable 12 et l'organe externe 2 peut être réalisée via un doigt, également désigné pion 122, qui est fixé sur la zone libre 121. Les termes « doigt » et « pion » peuvent être intervertis. Le terme « pion » ne se limite pas aux pièces de section constante et a fortiori aux pièces cylindriques.

Comme illustré sur la figure 1A, le pion 122 peut être plus particulièrement fixé au centre de la zone libre 121 de la membrane déformable 12, ou plus généralement symétriquement par rapport à l'étendue de la zone libre 121 de la membrane déformable 12. De la sorte, le pion 122 est déplacé, par la déformation élastique de la zone libre 121, dans un sens contrôlé, sensiblement vertical, et n'est pas, ou peu, incliné par rapport à la verticale lors de ses déplacements. Le débattement latéral du pion 122 est ainsi avantageusement limité.

**En** complément ou en alternative, l'organe externe 2 peut être structuré de sorte à comprendre un guide par lequel l'organe externe 2 est destiné à coopérer avec le pion 122. Ce guide peut lui aussi contribuer à s'opposer à une inclinaison du pion 122 lors de ses déplacements. Nous verrons plus tard que les limitations ainsi atteintes en termes de débattement latéral du pion 122 peuvent encore être renforcées par la présence d'au moins une butée latérale 15 s'étendant depuis une partie de la paroi 131 située hors de la zone libre 121 de la membrane déformable 12.

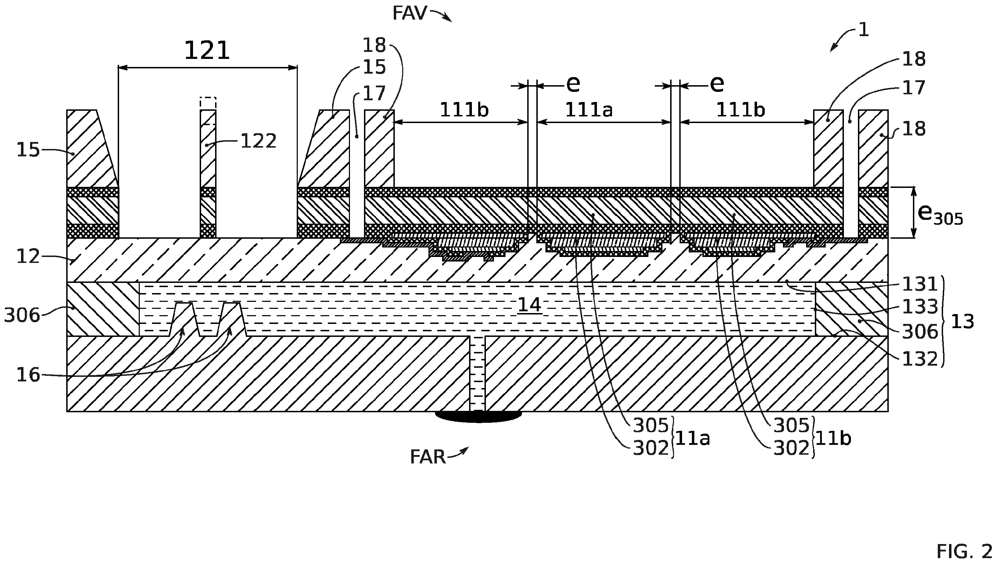

De façon non limitative, un collage ou une aimantation du pion 122 sur l'organe externe 2 peut permettre de solidariser entre eux le pion 122 et l'organe externe 2. L'énergie d'adhérence du pion 122 sur la zone libre 121 de la membrane déformable 12 est de préférence supérieure à celle du pion 122 sur l'organe externe 2. Nous verrons, lorsque nous décrirons le procédé de fabrication du microsystème électromécanique 1 illustré sur la figure 2 que l'énergie d'adhérence du pion 122 sur la zone libre 121 peut être une résultante d'étapes technologiques ordinaires dans le domaine de la micro-électronique. Cette énergie d'adhérence pouvant ainsi être estimée ou mesurée, il est aisé d'obtenir par collage, par exemple à l'aide d'une résine *ad hoc,* ou par aimantation, par exemple une solidarisation qui soit d'une énergie plus faible que l'énergie avec laquelle le pion 122 est solidarisé avec la membrane déformable 12. On comprend donc que la solidarisation entre le pion 122 et l'organe externe 2 est ainsi largement modulable en termes de force de retenue. Cette modularité peut permettre notamment de rendre amovible la solidarisation entre le pion 122 et l'organe externe 2, par exemple pour permettre à un même microsystème électromécanique 1 selon l'invention d'être agencé successivement avec plusieurs organes externes 2 avec chacun desquels il serait solidarisé, puis désolidarisé.

Comme illustré sur la figure 1A, chaque transducteur électromécanique 11a, 11b peut former une partie de la première paroi 131 de la cavité 13. Chacun des transducteurs électromécaniques 11a et 11b et la membrane déformable 12 sont ainsi placés d'un même côté de la cavité 13. Les structures présentant cette caractéristique sont avantageusement non traversantes, comme évoqué plus haut.

Sur cet exemple non limitatif, la membrane 12 présente une face interne 12i configurée pour être au contact du milieu déformable 14 et une face externe 12e. La face interne 12i forme au moins une partie de la première paroi 131 de la cavité 13. De préférence, pour assurer aisément l'herméticité de la cavité 13, la face interne 12i de la membrane déformable 12 forme toute la première paroi 131 de la cavité 13. Chaque transducteur électromécanique 11a, 11b, plus précisément la partie mobile 111a, 111b de ce dernier, présente une face interne 11i tournée au regard, et de préférence au contact de la face externe 12e de la membrane 12. Chaque transducteur électromécanique 11a, 11b présente également une face externe 11e, opposée à la face interne 11i, et tournée vers l'extérieur du microsystème électromécanique 1. De préférence, pour assurer aisément l'herméticité de la cavité 13, la face interne 11i de chaque transducteur électromécanique 11a, 11b est de préférence entièrement au contact de la face externe 12e de la membrane 12. On peut prévoir qu'une ou des couches intermédiaires soient disposées entre la face externe 12e de la membrane 12 et la face interne 11i de chaque transducteur 11a, 11b. Le microsystème électromécanique 1 est configuré de sorte que le mouvement de la partie mobile 111a, 111b de chaque transducteur électromécanique 11a, 11b provoque une déformation de la membrane 12 et donc de la première paroi 131 qui enferme le milieu 14.

On remarquera que, sur la figure 1A :
- chaque transducteur électromécanique 11a, 11b s'étend sur la membrane déformable 12, et
- la membrane déformable 12 sépare chaque transducteur électromécanique 11a, 11b, de préférence sur toute leur étendue, du milieu déformable 14.

En outre, chaque transducteur électromécanique 11a et 11b peut avantageusement être solidaire de la membrane déformable 12 sur une zone 123 située hors de la zone libre 121, et plus particulièrement sur une zone 123 distante de la zone libre 121, de sorte que tout mouvement de la partie mobile 111a, 111b de chaque transducteur 11a, 11b induise, notamment sur cette zone 123, un étirement ou une relaxation de la membrane déformable 12. Ainsi, dans l'exemple illustré sur la figure 1A, lorsque le premier transducteur 11a est sollicité de sorte à se déplacer vers le haut (comme illustré par la flèche en tirets s'étendant depuis la partie mobile 111a du premier transducteur 11a), une diminution de la pression externe exercée sur le milieu déformable 14 est observée, qui induit l'étirement de la membrane déformable 12 vers le bas, i.e. vers le centre de la cavité 13.

Toujours dans l'exemple illustré sur la figure 1A, lorsque le deuxième transducteur 11b est sollicité de sorte à se déplacer vers le bas (comme illustré par les flèches en trait plein s'étendant depuis la partie mobile 111b du deuxième transducteur électromécanique 11b), une augmentation de la pression externe exercée sur le milieu déformable 14 est observée, qui induit l'étirement de la membrane déformable 12 vers le haut, i.e. à l'opposé du centre de la cavité 13. Notons ici que cette solidarisation entre le deuxième transducteur 11b et la membrane déformable 12 n'est que préférentielle pour le microsystème illustré, dans la mesure où la partie mobile 111b du deuxième transducteur 11b est destinée à appuyer sur la membrane déformable 12 lorsque le deuxième transducteur 11b est sollicité et/ou dans la mesure où la membrane déformable 12 a naturellement tendance à rester au contact de la partie mobile 111b du deuxième transducteur 11b lorsque ce dernier n'appuie pas sur la membrane déformable 12.

A noter toutefois que, dans sa position d'équilibre, la partie mobile 111a, 111b d'un transducteur électromécanique 11a, 11b, voire de chaque transducteur, peut ne pas être plate, mais peut au contraire présenter une déflexion, dite à l'équilibre, qui n'enlève rien, en termes d'amplitude, à la capacité de déplacement ou de déflexion du transducteur 11a, 11b.

En référence aux figures 1A et 1B, un capot 18 peut être prévu qui est configuré, et qui est plus particulièrement suffisamment rigide, pour maintenir :
- la membrane 12 autour de la zone 123 sur laquelle s'étendent les premier et deuxième transducteurs 11a et 11b, la membrane 12 étant ainsi en partie située entre le capot 18 et le milieu déformable 14, et
- la partie non mobile du deuxième transducteur électromécanique 11b sur laquelle il s'étend.

Le capot 18 s'étend par exemple dans le plan xy. Il présente au moins une ouverture qui définit la zone dans laquelle s'étendent les parties mobiles desdits au moins deux transducteurs électromécaniques 11a et 11b. Le capot 18 peut s'étendre sur toute la première face 131 de la cavité 13, en projection sur le plan xy, à l'exception d'une zone située autour de la zone libre 121 de la membrane 12 Dans cette zone située autour de la zone libre 121 de la membrane déformable 12, ce sont des butées latérales 15 qui sont prévues (Cf. infra) et qui éventuellement prolongent le capot 18.

Comme illustré sur la figure 1A, au moins un espaceur 306 peut être prévu qui a essentiellement pour rôle de contribuer avec le capot 18 au maintien de la partie non mobile du deuxième transducteur 11b. Effectivement, ledit au moins un espaceur 306 illustré sur la figure 1A s'étend au moins au droit d'une partie du capot 18 qui, à droite de la figure, recouvre la partie non mobile du deuxième transducteur électromécanique 11b, cette partie non mobile étant ainsi pincée entre le capot 18 et l'espaceur 306. Ledit au moins un espaceur 306 peut en outre s'étendre au droit d'une partie d'au moins une butée latérale 15, et en particulier au droit d'une partie de ladite au moins une butée latérale 15 la plus excentrée, comme représenté sur la figure 1A. Ledit au moins un espaceur 306 peut former une partie au moins de la paroi latérale 133 de la cavité 13. Notons qu'il est également possible de prévoir un espaceur au droit d'une partie du capot 18 qui est centrée relativement à l'étendue de la cavité 13 dans le plan (x,y), et en particulier d'une telle partie du capot 18 qui s'étend également sur la partie non mobile du deuxième transducteur 11b.

La figure 1B illustre le recouvrement partiel de la membrane déformable 12 par les deux transducteurs électromécaniques 11a et 11b selon le premier mode de réalisation de l'invention. Le premier transducteur 11a y prend la forme d'un disque de rayon noté R1. Le deuxième transducteur 11b y prend la forme d'un anneau s'étendant autour du disque 11a sur une zone d'étendue radiale R2. Le disque 11a et l'anneau 11b sont de préférence concentriques. Le disque 11a et l'anneau 11b peuvent être, comme représentés, adjacents entre eux, l'anneau 11b présentant alors une étendue radiale égale à R2. En alternative, le disque 11a et l'anneau 11b peuvent être légèrement espacés entre eux, l'anneau 11b présentant alors une étendue radiale légèrement inférieure à R2.

Le rayon R1 du disque 11a est au plus égale aux deux tiers du rayon total R1+R2. L'étendue radiale R2 de la zone s'étendant autour du disque 11a est au plus égale au tiers du rayon total R1+R2. L'on s'assure ainsi que le premier transducteur électromécanique 11a et le deuxième transducteur électromécanique 11b ont des mouvements antagonistes entre eux, lorsqu'ils sont sollicités.

Le rayon total R1+R2 est de préférence inférieure à 900 µm, de préférence inférieure à 600 µm, de préférence inférieure à 300 µm.

Lorsque les premier et deuxième transducteurs 11a et 11b sont espacés entre eux, l'étendue radiale de cet espacement est par exemple compris entre 1 et 100 µm, et typiquement égale à 10 µm.

On comprend ici que chaque transducteur électromécanique 11a, 11b comprenant une partie mobile 111a, 111b qui lui est propre, la partie mobile d'un des deux transducteurs peut être sollicitée indépendamment, et notamment alternativement, à la partie mobile de l'autre transducteur. Il est alors avantageux que la déformation de la partie mobile 111a du premier transducteur électromécanique 11a soit antagoniste, et plus particulièrement dans un sens opposé dans la direction de l'axe z, à la déformation de la partie mobile 111b du deuxième transducteur électromécanique 11b. En effet, il est alors possible, même lorsque chacun des deux transducteurs 11a et 11b comprend un transducteur piézoélectrique à base de PZT, d'induire alternativement un éloignement et un rapprochement de l'organe externe 2, en fonction de celui des deux transducteurs 11a et 11b qui est sollicité. Par exemple, le premier transducteur électromécanique 11a est configuré pour se mouvoir vers le haut, i.e. à l'opposé du centre de la cavité 13, lorsqu'il est sollicité et le deuxième transducteur électromécanique 11b est configuré pour se mouvoir vers le bas, i.e. vers le centre de la cavité 13, lorsqu'il est sollicité.

En complément, il est avantageux que l'étendue radiale R2 du deuxième transducteur 11b soit environ deux fois plus petite que le rayon R1 du premier transducteur 11a. Dans une telle configuration, la partie mobile 111a du premier transducteur 11a et la partie mobile 111b du deuxième transducteur 11b peuvent être déplacées ou défléchies avec une amplitude sensiblement égale, lorsque les transducteurs sont alternativement et sensiblement pareillement sollicités.

Egalement lorsque le recouvrement partiel de la membrane déformable 12 par les deux transducteurs 11a et 11b est tel qu'illustré sur la figure 1B et que les transducteurs 11a et 11b sont des transducteurs piézoélectriques comprenant chacun un matériau piézoélectrique à base de PZT, le rayon R_{ZL} de la zone libre 121 de la membrane déformable 12 peut être sensiblement égal à 100 µm et le rayon R1 du premier transducteur électromécanique 11a peut être sensiblement égal à 200 µm. Les références R_{ZL} et R1 sont illustrées en figure 1B.

Toujours lorsque le recouvrement partiel de la membrane déformable 12 par les deux transducteurs 11a et 11b est tel qu'illustré sur la figure 1B et que les transducteurs 11a et 11b sont des transducteurs piézoélectriques comprenant chacun un matériau piézoélectrique à base de PZT, mais en référence à la figure 2 discutée plus en détails ci-dessous, chaque transducteur électromécanique 11a et 11b comprend plus particulièrement un élément constituant une poutre 305 et un élément piézoélectrique 302 à base de PZT, ce dernier étant configuré pour induire une déflexion de la poutre 305. L'épaisseur de l'élément piézoélectrique 302 peut être sensiblement égale à 0,5 µm et l'épaisseur de la poutre 305 est par exemple comprise entre quelques microns et plusieurs dizaines de microns ; par exemple, elle est sensiblement égale à 5 µm. Dans une telle configuration, lorsque R1 est égal à 200 microns et R2 est égal à 100 microns, l'amplitude de déplacement des parties mobiles 111a, 111b des transducteurs 11a et 11b peut par exemple atteindre une valeur égale à quelques microns, en particulier lorsque l'un ou l'autre des transducteurs 11a et 11b est parcouru par une tension électrique égale à quelques dizaines de volt.

On observe immédiatement sur la figure 1B que la zone libre 121 de la membrane 12 est à distance, ou est disjointe, de la zone 123 sur laquelle les deux transducteurs 11a et 11b recouvrent la membrane 12. Autrement dit, la zone libre 121 et la zone 123 ne se recouvrent pas l'une l'autre et ne sont pas non plus adjacentes entre elles. Une distance est donc ménagée entre la zone 121 et la zone 123.

On observe encore immédiatement sur la figure 1B que la zone libre 121 de la membrane 12 est décentrée par rapport à la zone 123 sur laquelle les deux transducteurs 11a et 11b recouvrent la membrane 12. Cette caractéristique est liée au fait que le premier transducteur 11a prend la forme d'un disque, et est donc plein.

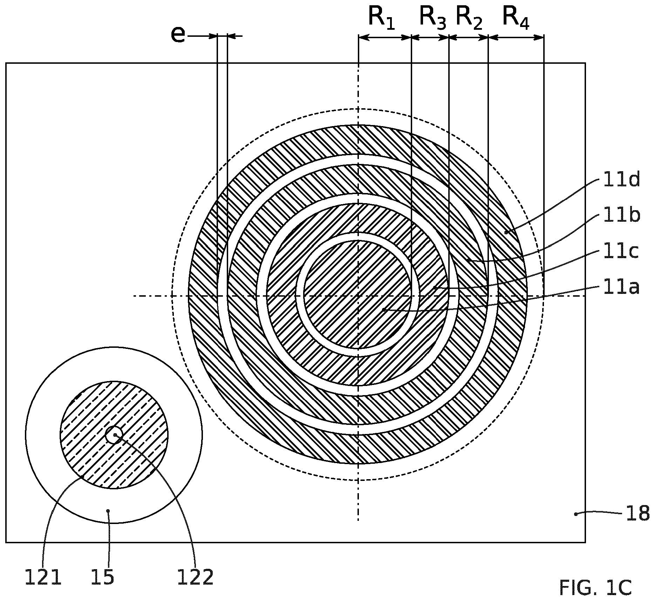

On observe encore, sur la figure 1B, que ladite au moins une butée latérale 15 peut prendre la forme d'un anneau s'étendant depuis la première paroi 131 de la cavité et autour de la zone libre 121 de la membrane 12. De mêmes observations peuvent être faites sur la base de la figure 1C.

La figure 1C illustre le recouvrement partiel de la membrane déformable 12 par quatre transducteurs électromécaniques 11a, 11b, 11c et 11d selon un deuxième mode de réalisation de l'invention. La figure 1C est plus particulièrement une vue de dessus du deuxième mode de réalisation du microsystème électromécanique selon l'invention. Dans ce deuxième mode de réalisation, ledit au moins un premier transducteur électromécanique 11a comprend au moins un transducteur électromécanique prenant la forme d'un disque d'étendue radiale R1 ; Ledit au moins un deuxième transducteur électromécanique 11b comprend au moins un transducteur électromécanique prenant la forme d'un anneau s'étendant autour du disque 11a sur une zone d'étendue radiale R2, comme dans le premier mode de réalisation décrit ci-dessus. Cependant, au contraire du premier mode de réalisation décrit ci-dessus, ledit au moins un premier transducteur électromécanique 11a et/ou ledit au moins un deuxième transducteur électromécanique 11b selon le deuxième mode de réalisation de l'invention peut comprendre un ou plusieurs autres transducteurs électromécaniques. Ainsi, selon l'exemple illustré sur la figure 1C, le microsystème électromécanique 1 peut comprendre un troisième transducteur électromécanique 11c prenant la forme d'un anneau et s'étendant entre le disque 11a et l'anneau 11b sur une zone d'étendue radiale R3, et un quatrième transducteur électromécanique 11d prenant la forme d'un anneau s'étendant autour de l'anneau 11b sur une zone d'étendue radiale R4. Les transducteurs 11a, 11b, 11c et 11d selon le deuxième mode de réalisation de l'invention sont de préférence concentriques. Les transducteurs électromécaniques radialement successifs entre eux sont soit espacés, soit adjacents. Leurs parties mobiles sont par exemple séparées entre elles d'une distance notée e sur la figure 1C. Cette distance peut être rapprochée de celle notée également e sur la figure 2 détaillée ci-dessous. Toutefois, sur cette dernière figure, la distance e vise davantage à illustrer qu'il est nécessaire que les éléments piézoélectriques 302 de transducteurs adjacents entre eux ne doivent pas se toucher pour pouvoir être isolés électriquement entre eux, qu'à illustrer qu'il est possible d'espacer entre eux les transducteurs, y compris lorsque ceux-ci sont agencés de façon concentrique entre eux.

La déformation des parties mobile des transducteurs 11a et 11c peut avantageusement être antagoniste à la déformation des parties mobiles des transducteurs 11b et 11d. A cette fin, les transducteurs 11a et 11c peuvent s'inscrire dans un disque de rayon inférieur aux 2/3 de l'étendue radiale totale R1+R3+R2+R4 des transducteurs.

En alternative, le transducteur 11a peut s'inscrire dans une première zone circulaire de rayon inférieur aux deux tiers de l'étendue radiale totale R1+R3+R2+R4 des transducteurs et les trois autres transducteurs 11b, 11c et 11d peuvent s'étendre au-delà de la première zone circulaire sur une zone annulaire d'étendue radiale inférieure au tiers de l'étendue radiale totale R1+R3+R2+R4 des transducteurs.

Une autre alternative consiste à considérer que les trois transducteurs 11a, 11b et 11c sont situés dans la première zone circulaire de rayon inférieur aux deux tiers de l'étendue radiale totale R1+R3+R2+R4 et que le quatrième transducteur électromécanique 11d est situé dans la zone annulaire d'étendue radiale inférieure aux tiers de l'étendue radiale totale R1+R3+R2+R4 des transducteurs s'étendant autour de la première zone circulaire.

Comme déjà discuté ci-dessus en référence au mode de réalisation illustré sur la figure 1B, il est possible, même lorsque chacun des transducteurs 11a, 11b, 11c et 11d comprend un transducteur piézoélectrique à base de PZT, d'induire alternativement un éloignement et un rapprochement de l'organe externe 2, en fonction de celui des transducteurs électromécaniques 11a, 11b, 11c et 11d qui est sollicité. L'n comprend en outre qu'un avantage additionnel, par rapport au premier mode de réalisation illustré schématiquement sur les figures 1A et 1B, consiste en ce que le deuxième mode de réalisation peut permettre d'obtenir au moins deux niveaux d'éloignement de l'organe externe 2 différents entre eux et/ou au moins deux niveaux de rapprochement de l'organe externe 2 différents entre eux. Le microsystème électromécanique 1 selon le deuxième mode de réalisation de l'invention constitue donc un actionneur pas à pas, propre à déplacer l'organe externe 2 entre au moins quatre positions d'élévation et/ou de rapprochement, y compris lorsque chacun des transducteurs 11a, 11b, 11c et 11d fonctionne sur un mode binaire.

Notons ici que le microsystème électromécanique 1 selon le deuxième mode de réalisation n'est pas limité à l'exemple illustré comprenant trois transducteurs 11b, 11c et 11d présentant chacun une forme annulaire. Plus particulièrement, le deuxième mode de réalisation s'étend à un cas comprenant deux transducteurs de forme annulaire et un cas comprenant plus de trois transducteurs de forme annulaire.

Notons que, quel que soit celui des modes de réalisation du microsystème électromécanique selon l'invention, chaque transducteur électromécanique 11a, 11b, 11c, 11d n'est pas limité à une forme annulaire ou de disque, mais peut prendre d'autres formes, et notamment une forme, creuse ou pleine, oblongue, ovale, triangulaire, rectangulaire, etc.

Notamment lorsque le recouvrement partiel de la membrane déformable 12 par les transducteurs électromécaniques est tel qu'illustré sur l'une des figures 1B et 1C et que chaque transducteur électromécanique est un transducteur piézoélectrique comprenant un matériau piézoélectrique à base de PZT, il est intéressant que la partie mobile de chaque transducteur électromécanique présente une surface au moins 2 fois supérieure à la surface de la zone libre 121 de la membrane déformable 12. La membrane déformable 12 est dès lors configurée de sorte que sa zone libre 121 est capable de se déformer avec une amplitude d'au moins 50 µm, d'environ 100 µm, voire de plusieurs centaines de µm. De préférence, la surface des parties mobiles des transducteurs 11a et 11b illustrés sur la figure 1B, ou des transducteurs 11a, 11b, 11c et 11d illustrés sur la figure 1C, est au moins 5 fois, voire 10 fois, voire 20 fois supérieure à la surface de la zone libre 121 de la membrane déformable 12 illustrée sur les mêmes figures.

De manière générale, la membrane déformable 12 est de préférence configurée de sorte que sa zone libre 121 est capable de se déformer avec une amplitude inférieure à 1 mm.

L'amplitude de déformation de la zone libre 121 est mesurée selon une direction perpendiculaire au plan dans lequel s'étend principalement la face externe 12e de la membrane 12 au repos.

Sans se déchirer et/ou sans usure significative, le microsystème électromécanique 1 permet une amplification hydraulique de l'action et offre ainsi la capacité à satisfaire de nombreuses et diverses applications nécessitant un grand débattement. Dans ce contexte, le microsystème électromécanique 1 selon chacun des deux modes de réalisation décrits ci-dessus peut être défini comme un actionneur à grand débattement ascendant ou descendant.

Toujours lorsque le recouvrement partiel de la membrane déformable 12 par les transducteurs électromécaniques est tel qu'illustré sur les figures 1B et 1C et que chaque transducteur électromécanique est un transducteur piézoélectrique comprenant un matériau piézoélectrique à base de PZT, mais en référence à la figure 2 discutées plus en détails ci-dessous, chaque transducteur électromécanique 11a , 11b comprend plus particulièrement un élément constituant une poutre 305 et un élément piézoélectrique 302 à base de PZT, ce dernier étant configuré pour induire une déflexion de la poutre 305. L'épaisseur de l'élément piézoélectrique 302 est par exemple sensiblement égale à 0,5 µm et l'épaisseur de la poutre 305 est par exemple comprise entre quelques µm et plusieurs dizaines de µm, par exemple 5 µm.

L'invention n'est toutefois pas limitée aux différentes valeurs spécifiques données ci-dessus qui peuvent être largement adaptées, en fonction de l'application visée, notamment pour trouver un compromis entre facteur d'étirement et amplitude de déformation attendue de la zone libre 121 de la membrane déformable 12.

Notons que, notamment lorsqu'un des transducteurs électromécaniques est un transducteur piézoélectrique, il peut avantageusement être un transducteur à fonctionnement vibratoire. Sa fréquence de résonance est alors de préférence inférieure à 100 kHz, et encore plus préférentiellement inférieures à 1 kHz. La dynamique vibratoire ainsi obtenue peut permettre d'atteindre des débattements plus grands qu'en fonctionnement statique, notamment en exploitant le phénomène de résonnance afférent ou de diminuer la consommation du microsystème électromécanique pour un débattement donné.

Comme déjà mentionné plus haut, le microsystème électromécanique 1 peut comprendre en outre une ou plusieurs butées latérales 15 supportées par la paroi 131 de la cavité 13. Chaque butée latérale 15 s'étend plus particulièrement à l'opposé de la cavité 13.

Relativement à au moins l'une des butées latérales 15, le pion 122 peut s'étendre, à l'opposé de la cavité 13, au-delà ou en deçà (Cf. figure 2). La butée latérale 15 entourant la zone libre 121 peut également être configurée pour permettre le guidage et l'auto-positionnement de l'organe externe 2 sur le microsystème électromécanique 1. Elle contribue encore à limiter, voire à annihiler, le risque d'arrachement de la membrane déformable 12 lors du report de l'organe externe 2 sur le microsystème électromécanique 1. Notons ici que, dépendant de l'étendue de l'organe externe 2, elle peut également jouer le rôle de butée haute limitant le rapprochement de l'organe externe 2 vers le microsystème électromécanique 1. Cette particularité peut également permettre d'induire une désolidarisation du pion 122 et de l'organe externe 2 entre eux en tirant le pion 122 dans une position plus basse que celle possiblement atteinte par l'organe externe 2 du fait que ce dernier bute sur le haut de la butée latérale 15. Plus précisément, une telle butée latérale 15 présente une surface de butée configurée pour stopper le déplacement de l'organe 12. Le microsystème électromécanique 1 est configuré de sorte à ce que, lorsque le déplacement de l'organe 12 est stoppé dans son déplacement, selon un sens donné, par la butée latérale 15, le pion 122 peut poursuivre son déplacement, dans ce même sens. Le pion 122 se désolidarise ainsi de l'organe 12.

Comme illustré sur chacune des figures 1A et 2, le microsystème électromécanique 1 peut comprendre en outre une ou plusieurs butées dites basses 16 supportées par la paroi 132 de la cavité 13 qui est opposée à la paroi 131 formée au moins en partie par la membrane déformable 12 et s'étendant dans la cavité 13 vers la zone libre 121 de la membrane déformable 12. Cette butée basse 16 présente de préférence une forme et des dimensions configurées pour limiter la déformation de la zone libre 121 de la membrane déformable 12 de sorte à protéger la membrane déformable 12, et plus particulièrement sa zone libre 121, d'un éventuel arrachement, notamment lors du report de l'organe externe 2 sur le microsystème électromécanique 1. De manière alternative ou cumulée, la butée basse 16 est conformée de sorte à limiter la surface de contact entre la membrane 12 et la paroi 132 de la cavité 13 opposée à la zone libre 121 de la membrane 12 déformable. Cela permet d'éviter que la membrane 12 n'adhère et ne se colle à cette paroi 132.

Un mode de réalisation de l'invention plus spécifique que celui décrit ci-dessus est illustré sur la figure 2 sur laquelle les mêmes références que sur les figures 1A et 1B référencient les mêmes objets.

On y observe tout d'abord que chaque transducteur électromécanique 11a, 11b illustré comprend une poutre 305 et un matériau piézoélectrique 302 configuré pour déformer la poutre 305 lorsqu'il est parcouru par un courant électrique. Plus particulièrement, les transducteurs 11a et 11b partage une même poutre 305, leurs éléments piézoélectriques 302 étant agencés en regard de zones différentes de la poutre 305. L'on comprend que l'élément piézoélectrique 302 du premier transducteur 11a est propre à déformer principalement une zone centrale de la poutre 305, tandis que l'élément piézoélectrique 302 du deuxième transducteur est propre à déformer principalement une zone de la poutre 305 périphérique à ladite zone centrale.

On observe également sur la figure 2, les différentes hauteurs que peuvent présenter le pion 122 relativement à la hauteur de la butée latérale 15 qui entoure la zone 121. On n'y observe encore que les butées latérales 15 et les butées basses 16, et/ou leur section, peuvent prendre différentes formes, et notamment une forme parallélépipédique, une forme tronconique, une forme sensiblement pyramidale, etc.

On observe en outre, sur la figure 2, que la partie mobile 111a, 111b de chaque transducteur électromécanique 11a, 11b peut être sensiblement définie par l'étendue de l'élément piézoélectrique 302 relativement à l'étendue de la poutre 305.

Sur la figure 2, on observe également des ouvertures d'accès pour une connexion électrique des électrodes. Ces ouvertures forment dans ces exemples des via 17. Dans cet exemple, les vias 17 traversent toute l'épaisseur de la poutre 305. L'épaisseur e₃₀₅ de la poutre 305 est mesurée selon une direction perpendiculaire au plan dans lequel s'étend principalement les faces 12e et 12i de la membrane 12. L'épaisseur e₃₀₅ est référencée en figure 2.

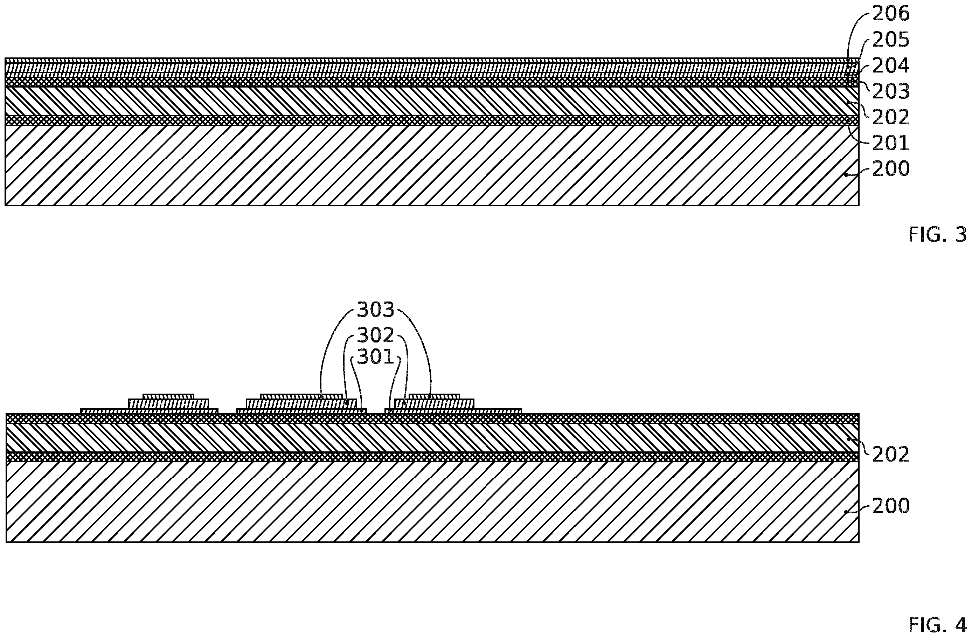

La figure 2 illustre plus particulièrement, que ne le font les figures 1A et 1B, le premier mode de réalisation de l'invention déjà discuté plus haut. Notamment, la figure 2 montre le premier mode de réalisation de l'invention tel qu'obtenu par des étapes de dépôt et de gravure pouvant être qualifiées comme ordinaires dans le domaine de la microélectronique (et ce peut être également le cas du deuxième mode de réalisation de l'invention). Plus particulièrement, le microsystème électromécanique 1 selon le premier mode de réalisation illustré sur la figure 2 a été obtenu par la succession d'étapes illustrées par les figures 3, 4, 5, 6, 7, 8 et 9. Ainsi, un procédé de fabrication est illustré qui mène au microsystème électromécanique 1 illustré sur la figure 2.

Ce procédé de fabrication comprend au moins :
- une étape de formation de ce qui est destiné à constituer une portion au moins de chaque transducteur électromécanique 11a, 11b sur un substrat 200, puis
- une étape de dépôt de la membrane déformable 12, puis
- une étape de formation d'une cavité 13 ouverte sur la membrane déformable 12, puis
- une étape de remplissage avec le milieu déformable et de fermeture de la cavité 13, et
- une étape de gravure du substrat 200 pour former la face avant du microsystème électromécanique illustré sur la figure 2.

Nous décrivons ci-dessous successivement le procédé de fabrication susmentionné du microsystème électromécanique 1 tel qu'illustré sur la figure 2.

La première étape de ce procédé est illustrée sur la figure 3. Elle consiste à fournir un substrat 200 sur lequel un empilement de couches s'étend qui peut comprendre successivement, depuis une face du substrat 200 :
- une première couche isolante 201, par exemple à base d'oxyde de silicium, pouvant être déposée par dépôt chimique en phase vapeur assisté par plasma (ou PECVD, pour Plasma-Enhanced Chemical Vapor Deposition en anglais),
- une couche 202 destinée à constituer la poutre 305 des transducteurs électromécaniques 11a et 11b, cette couche 202 étant par exemple à base de silicium amorphe, polycristallin ou monocristallin, et pouvant être déposée par dépôt chimique en phase vapeur (ou CVD pour l'anglais chemical vapor deposition) à pression sous-atmosphérique (ou LPCVD), ou par utilisation d'une structure de type SOI (pour « Silicon On Insulator » ou, en français, silicium sur isolant),
- une deuxième couche isolante 203, par exemple à base d'oxyde de silicium et pouvant être déposée par PECVD,
- une couche 204 destinée à constituer une électrode dite inférieure, par exemple à base de platine et pouvant être déposée par dépôt physique en phase vapeur (ou PVD pour l'anglais physical vapor deposition),
- une couche 205 en un matériau piézoélectrique, par exemple à base de PZT, et pouvant être déposée par un procédé sol gel, et
- une couche 206 destinée à constituer une électrode dite supérieure, par exemple à base de platine et pouvant être déposée par PVD.

La deuxième étape du procédé de fabrication du microsystème électromécanique 1 tel qu'illustré sur la figure 2 est illustrée sur la figure 4. Elle comprend :
- une gravure de la couche 206 de sorte à former l'électrode supérieure 301 de chaque transducteur électromécanique 11a, 11b,
- une gravure de la couche 205 de sorte à former les éléments piézoélectriques 302 des transducteurs électromécaniques 11a, 11b, et
- une gravure de la couche 204 de sorte à former l'électrode inférieure 303 de chaque transducteur électromécanique 11a, 11b.

Notons que chacune de ces gravures peut être réalisée par lithographie, et préférentiellement par gravure au plasma, ou par voie chimique humide.

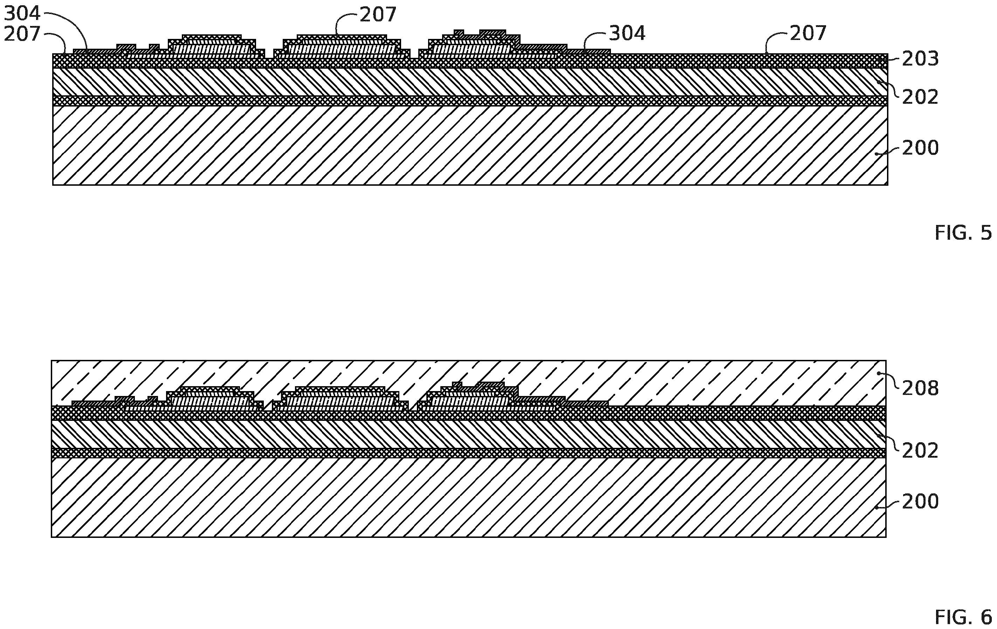

La troisième étape du procédé de fabrication du microsystème électromécanique 1 tel qu'illustré sur la figure 2 est illustrée sur la figure 5. Elle comprend :
- le dépôt d'une couche de passivation 207, par exemple à base d'oxyde de silicium et/ou de nitrure de silicium, pouvant être déposée par PECVD,
- l'ouverture, à travers la couche de passivation 207, d'une zone de reprise de contact par électrode, cette ouverture étant réalisée par exemple par lithographie, et préférentiellement par gravure au plasma, ou par voie chimique humide,
- le dépôt d'une couche destinée à constituer une ligne électrique 304 par électrode, la couche étant par exemple à base d'or et pouvant être déposée par PVD, et
- une gravure de la couche précédemment déposée de sorte à former une ligne électrique 304 par électrode, cette gravure étant réalisée par exemple par lithographie, et préférentiellement par gravure au plasma, ou par voie chimique humide.

La quatrième étape du procédé de fabrication du microsystème électromécanique 1 tel qu'illustré sur la figure 2 est illustrée sur la figure 6. Elle comprend le dépôt d'une couche 208 à base d'un polymère et destinée à constituer la membrane déformable 12. Cette couche 208 est par exemple déposée par enduction centrifuge (ou *spin coating* en anglais). Le polymère à base duquel la couche 208 est constituée est par exemple à base de PDMS.

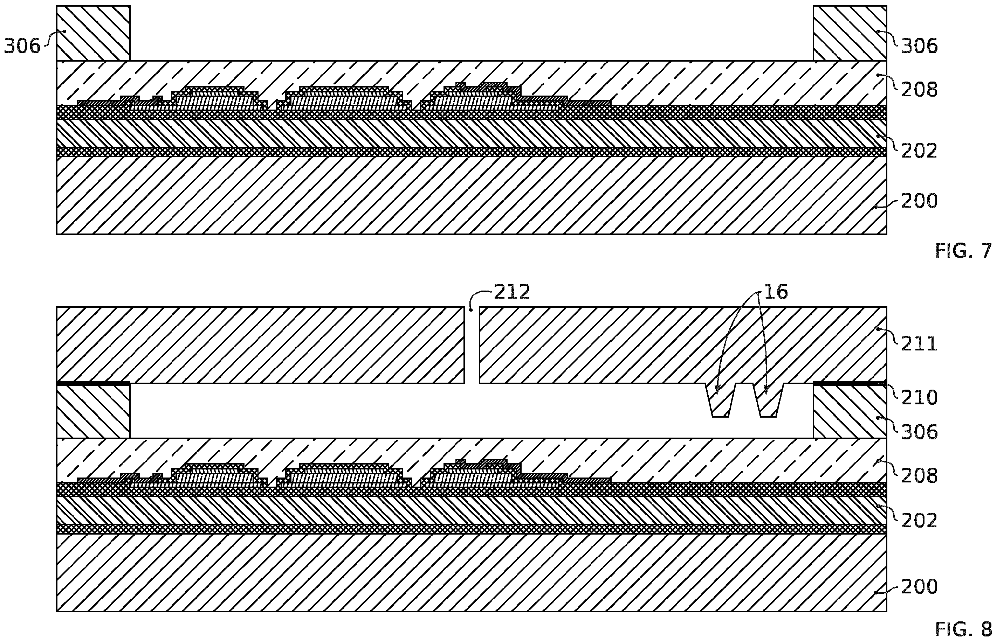

La cinquième étape du procédé de fabrication du microsystème électromécanique 1 tel qu'illustré sur la figure 2 est illustrée sur la figure 7. Elle comprend la formation d'au moins un espaceur 306 destiné à constituer au moins une partie de ladite au moins une paroi 133 latérale de la cavité 13. La formation du ou des espaceurs peut comprendre le laminage d'un matériau photosensible à base duquel le ou les espaceurs sont constitués, l'insolation, puis le développement du matériau photosensible. Ledit matériau photosensible peut être à base d'un polymère, et notamment à base de Siloxane. Le laminage du matériau photosensible peut comprendre le laminage d'un film sec dudit matériau.

La sixième étape du procédé de fabrication du microsystème électromécanique 1 tel qu'illustré sur la figure 2 est illustrée sur la figure 8. Selon un mode de réalisation optionnelle, cette étape comprend le dépôt de colle 210 au sommet de chaque espaceur 306, ce dépôt pouvant être réalisé par sérigraphie ou par dispense. Elle comprend la fixation, par exemple le collage, sur le sommet du ou des espaceurs (éventuellement par l'intermédiaire de la colle), d'un second substrat 211 pouvant être structuré de sorte à comprendre au moins l'un parmi un évent traversant 212 et une butée basse 16 telle que décrite ci-dessus. Dans un mode de réalisation alternatif, selon la nature de l'espaceur, celui-ci peut jouer le rôle de colle. À l'issue de cette sixième étape, la cavité 13 est formée qui est ouverte par au moins un évent traversant 212.

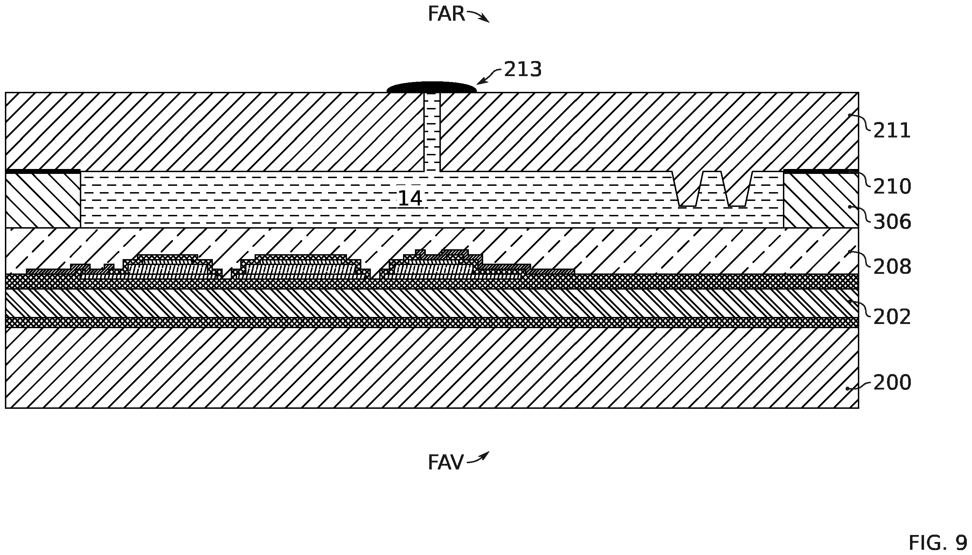

La septième étape du procédé de fabrication du microsystème électromécanique 1 tel qu'illustré sur la figure 2 est illustrée sur la figure 9. Elle comprend le remplissage, de préférence sous vide, de la cavité 13 avec le milieu déformable 14 tel que décrit ci-dessus, par exemple par dispense à travers l'au moins un évent traversant 212. Elle comprend également la fermeture étanche de l'au moins un évent traversant 212, par exemple par dispense d'un matériau de scellement 213 à l'embouchure de chaque évent traversant 212, le matériau de scellement 213 étant par exemple à base d'une colle époxy.

La huitième étape du procédé de fabrication du microsystème électromécanique 1 tel qu'illustré sur la figure 2 est l'étape permettant de l'obtenir. Elle comprend la gravure du substrat 200. Cette gravure peut être réalisée par lithographie, et préférentiellement par gravure au plasma, ou par voie chimique humide. Elle comprend ensuite la gravure de la couche 202 et des couches isolantes 201, 203 de sorte à former au moins une poutre 305 des transducteurs électromécaniques 11a, 11b, à exposer une partie de la membrane déformable 12 et à constituer tout ou partie du pion 122, du capot 18 et des éventuelles butées latérales 15.

Notons que, suite aux étapes décrites ci-dessus de fabrication du microsystème électromécanique 1 tel qu'illustré sur la figure 2, le pion 122 prend la forme d'un empilement s'étendant directement depuis la membrane déformable 12 à l'opposé de la cavité 13 en présentant successivement le matériau de la couche isolante 201, le matériau constituant la poutre 305, le matériau de la couche isolante 203 et le matériau constituant le substrat 200. Notons également que, suite aux étapes décrites ci-dessus de fabrication du microsystème électromécanique 1 tel qu'illustré sur la figure 2, les éventuelles butées latérales 15 prennent chacune la forme d'un empilement s'étendant, directement ou indirectement, depuis la membrane déformable 12 à l'opposé de la cavité 13 en présentant successivement le matériau de la couche isolante 201, le matériau constituant la poutre 305, le matériau de la couche isolante 203 et le matériau constituant le substrat 200.

Notons également que le capot 18 discuté plus haut est lui aussi formé par la mise en œuvre des étapes technologiques illustrées sur les figures 3 à 9. Le capot 18 prend la forme d'un empilement structuré s'étendant en partie directement et en partie indirectement depuis la membrane déformable 12 à l'opposé de la cavité 13 en présentant successivement le matériau de la couche isolante 201, le matériau constituant la poutre 305 et le matériau de la couche isolante 203. La partie du capot 18 s'étendant indirectement depuis la membrane 12 recouvre la partie non mobile du deuxième transducteur électromécanique 11b.

Il est à noter ici que, si le capot 18 n'est pas nécessairement aussi épais que ladite au moins une butée latérale 15 (qui e elle potentiellement un rôle de limitation du débattement du pion 122, contrairement au capot 18), il est tout de même possible afin d'augmenter le cas échéant la rigidité du capot 18 et/ou de mieux s'assurer de l'immobilité des parties non mobiles des transducteurs, que le capot 18 prenne la même composition et la même étendue en épaisseur que ladite au moins une butée latérale 15. Les deux sont alors confondus indissociables l'un avec l'autre.

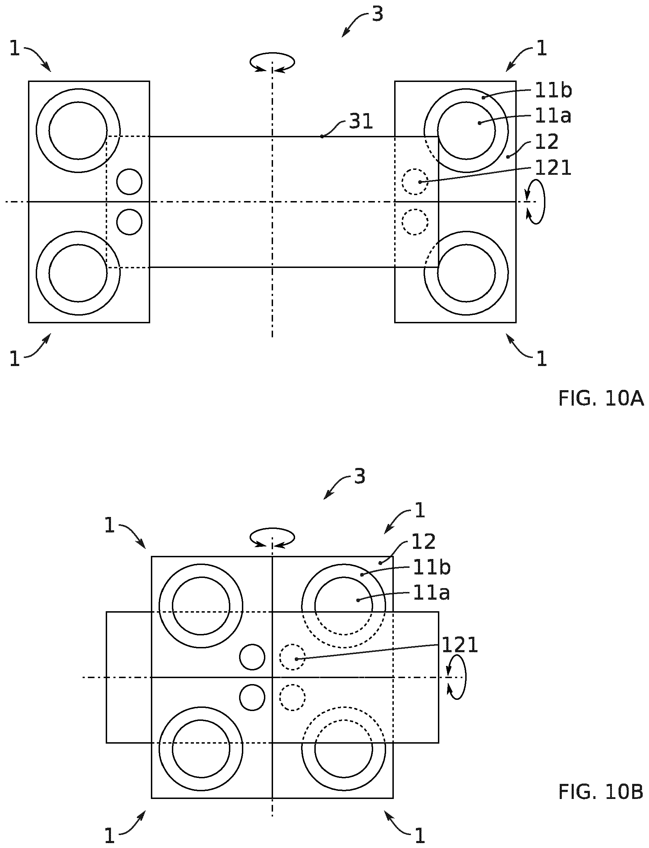

Un autre aspect de l'invention concerne un système opto-électro-mécanique 3 tel qu'illustré sur les figures 10A, 10B, 11A et 11B. Il peut s'agir d'un microsystème opto-électro-mécanique 3. Chacun des microsystèmes opto-électro-mécaniques 3 illustrés sur ces figures comprend au moins un microsystème électromécanique 1 tel que décrit ci-dessus et au moins un microsystème optique 31. Ledit au moins un microsystème électromécanique 1 est de préférence monté sur un support 32 du microsystème opto-électro-mécanique 3. Ledit au moins un microsystème optique 31 peut comprendre un micro-miroir à base de silicium, dont la surface est le cas échéant surmontée d'au moins un miroir. Il peut être monté directement sur ledit au moins un microsystème électromécanique 1 ou y être monté par l'intermédiaire d'un cadre 33. Il peut présenter des dimensions sensiblement égales à 2 mm × 5 mm et/ou, au maximum, une épaisseur d'environ 700 µm. Les microsystèmes opto-électro-mécaniques 3 tels qu'illustrés comprennent chacun quatre microsystèmes électromécaniques 1 présentant chacun une zone libre 121 agencée en vis-à-vis d'une partie d'un même microsystème optique 31, cette partie lui étant propre et étant de préférence un coin dudit microsystème optique 31 ou de son centre. On obtient ainsi un microsystème opto-électro-mécanique 1 bénéficiant d'une large capacité d'adaptation de son orientation optique.

Notons également que, du fait de la possibilité qu'offre chaque microsystème électromécanique 1 selon l'invention d'agir sur le microsystème optique 31 en le déplaçant alternativement vers le haut et vers le bas, les angles d'inclinaison du microsystème optique 31 atteignables sont ainsi avantageusement d'une amplitude augmentée, relativement à des micros système électromécaniques ne permettant d'agir sur le microsystème optique 31 que dans un sens, vers le haut ou vers le bas.

Notons en outre que, du fait du décentrage de la zone libre 121 de la membrane déformable 12 relativement à la zone 123 sur laquelle s'étendent les transducteurs électromécaniques 11a et 11b, il est possible d'agencer les zones libres 121 des quatre microsystèmes électromécaniques 1 au plus près des coins ou du centre du microsystème optique 31, et en particulier potentiellement plus près que ne le permettraient des microsystèmes électromécaniques dans chacun desquels la zone libre 121 de la membrane déformable 12 serait centrée sur la zone 123 des transducteurs électromécaniques. Les angles d'inclinaison du microsystème optique 31 atteignables sont ainsi avantageusement d'une amplitude augmentée.

L'invention n'est pas limitée aux modes de réalisation précédemment décrits et s'étend à tous les modes de réalisation couverts par les revendications.

Notamment, d'autres applications que celles décrites ci-dessus sont envisageables. Par exemple, le microsystème électromécanique 1 peut être agencé dans une micropompe, voire dans un système à tableau de micropompes, dans un système haptique, ou dans un système à membrane vibratoire, et éventuellement acoustique.

## Revendications

1. Microsystème électromécanique (1) comprenant :
- au moins deux transducteurs électromécaniques (11a et 11b) comprenant chacun une partie mobile (111a, 111b) entre une position d'équilibre, hors sollicitation, et une position hors équilibre, sous sollicitation,
- au moins une membrane déformable (12),
- une cavité (13) déformable, délimitée par des parois (131, 132, 133), au moins une partie de la membrane déformable (12) formant au moins une partie d'une première paroi (131) prises parmi lesdites parois (131, 132, 133) de la cavité (13), la cavité (13) contenant hermétiquement un milieu déformable (14) conservant un volume sensiblement constant sous l'action d'un changement de pression externe exercée sur le milieu déformable (14) à travers l'une des parois (131, 132, 133) de la cavité (13),
dans lequel la partie mobile (111a, 111b) de chaque transducteur électromécanique (11a, 11b) est configurée de sorte que son mouvement soit fonction dudit changement de pression externe, ou inversement que son mouvement induise un changement de pression externe, et dans lequel ladite au moins une partie de la membrane déformable (12) présente au moins une zone libre (121) de se déformer, en fonction dudit changement de pression externe,
le microsystème électromécanique (1) étant en outre tel que :
la zone libre (121) étant configurée pour coopérer avec au moins un organe externe (2) de sorte que sa déformation induise, ou soit induite par, un mouvement de l'organe externe (2), la zone libre (121) de la membrane déformable (12) est configurée pour coopérer avec l'organe externe (2) via un pion (122) fixé sur ladite zone libre (121), de préférence au contact de ladite zone libre (121),
la partie mobile (111a) d'au moins un premier transducteur électromécanique (11a) est configurée de sorte que sa sollicitation ou une augmentation de pression externe induise son mouvement vers l'extérieur de la cavité (13), et
la partie mobile (111b) d'au moins un deuxième transducteur électromécanique (11b) est configurée de sorte que sa sollicitation ou une diminution de pression externe induise son mouvement vers l'intérieur de la cavité (13), et
dans lequel lesdits au moins deux transducteurs électromécaniques (11a et 11b) s'étendent sur une même paroi choisie parmi les parois (131, 132, 133) de la cavité (13) et à distance de la zone libre (121) de la membrane déformable (12).

2. Microsystème électromécanique (1) selon la revendication précédente, dans lequel ledit au moins un premier transducteur électromécanique (11a) comprend au moins un premier transducteur électromécanique ayant la forme d'un disque de rayon R1 et ledit au moins un deuxième transducteur électromécanique (11b) comprend au moins un deuxième transducteur électromécanique ayant la forme d'un anneau d'étendue radiale R2.

3. Microsystème électromécanique (1) selon la revendication précédente, dans lequel ledit au moins un premier transducteur électromécanique (11a) et ledit au moins un deuxième transducteur électromécanique (11b) s'inscrivent étroitement dans une zone circulaire de rayon déterminé, appelé « rayon total » et noté Rₜₒₜ, ladite zone circulaire étant composée de deux parties :
- une première partie prenant la forme d'un disque centré sur ladite zone circulaire et
- une seconde partie prenant la forme d'un anneau s'étendant autour de la première partie,
ledit au moins un premier transducteur électromécanique (11a) s'inscrit plus particulièrement dans la première partie de la zone circulaire et ledit au moins un deuxième transducteur électromécanique (11b) s'inscrit plus particulièrement dans la seconde partie de la zone circulaire,
la première partie de la zone circulaire présente un rayon R_{2/3} sensiblement égale aux deux tiers du rayon total et la seconde partie de la zone circulaire présente une étendue radiale E_{1/3} sensiblement égale au tiers du rayon total.

4. Microsystème électromécanique (1) selon la revendication précédente, dans lequel ledit au moins un premier transducteur électromécanique (11a) comprend en outre au moins un premier transducteur électromécanique (11c) ayant la forme d'un anneau, chaque premier transducteur électromécanique (11c) ayant la forme d'un anneau s'étendant autour du premier transducteur électromécanique (11a) ayant la forme d'un disque et le cas échant autour d'un autre premier transducteur électromécanique ayant la forme d'un anneau et/ou ledit au moins un deuxième transducteur électromécanique (11b) comprend une pluralité de deuxièmes transducteurs électromécaniques (11b, 11d) ayant chacun la forme d'un anneau et étant agencés de façon adjacente et concentrique entre eux.

5. Microsystème électromécanique (1) selon la revendication 3, dans lequel ledit au moins un premier transducteur électromécanique (11a) est constitué d'un premier transducteur électromécanique ayant la forme d'un disque de rayon R1 et ledit au moins un deuxième transducteur électromécanique (11b) est constitué d'un deuxième transducteur électromécanique ayant la forme d'un anneau d'étendue radiale R2.

6. Microsystème électromécanique (1) selon la revendication précédente, dans lequel l'étendue radiale R2 de l'anneau formé par le deuxième transducteur électromécanique (11b) est environ deux fois plus petite que le rayon R1 du disque formé par le premier transducteur électromécanique (11a).

7. Microsystème électromécanique (1) selon l'une quelconque des deux revendications précédentes, dans lequel le rayon R1 du disque formé par le premier transducteur électromécanique (11a) est au maximum égal au 2/3 de la somme Rₜₒₜ du rayon R1 du disque formé par le premier transducteur électromécanique (11a) et de l'étendue radiale R2 de l'anneau formé par le deuxième transducteur électromécanique (11b), et l'étendue radiale R2 de l'anneau formé par le deuxième transducteur électromécanique (11b) est au maximum égale à 1/3 de la somme Rₜₒₜ du rayon R1 du disque formé par le premier transducteur électromécanique (11a) et de l'étendue radiale R2 de l'anneau formé par le deuxième transducteur électromécanique (11b).

8. Microsystème électromécanique (1) selon l'une quelconque des revendications précédentes, dans lequel lesdits au moins deux transducteurs électromécaniques (11a et 11b) sont concentriques.

9. Microsystème électromécanique (1) selon l'une quelconque des revendications précédentes, dans lequel, avec au moins une partie desdits au moins deux transducteurs électromécaniques (11a, 11b) formant une partie de ladite première paroi (131) de la cavité (13), ledit au moins deuxième transducteur électromécanique (11b) est configuré de sorte qu'un mouvement de sa partie mobile (111b) de sa position d'équilibre à sa position hors équilibre induise un accroissement de la pression externe agissant sur le milieu déformable (14) et dans lequel la membrane déformable (12) est configurée de sorte qu'un accroissement de la pression externe agissant sur le milieu déformable (14) induise une déformation de la zone libre (121) de la membrane déformable (12) tendant à l'éloigner d'au moins une deuxième paroi (132, 133) de la cavité (13), la deuxième paroi (132, 133) étant différente de la première paroi (131) et restant fixe lorsque la membrane déformable (12) se déforme.

10. Microsystème électromécanique (1) selon l'une quelconque des revendications précédentes, dans lequel ledit au moins un premier transducteur électromécanique (11a) est configuré de sorte qu'un mouvement de sa partie mobile (111a) de sa position d'équilibre à sa position hors équilibre induise une diminution de la pression externe agissant sur le milieu déformable (14) et dans lequel la membrane déformable (12) est configurée de sorte qu'une diminution de la pression externe agissant sur le milieu déformable (14) induise une déformation de la zone libre (121) de la membrane déformable (12) tendant à la rapprocher d'au moins une deuxième paroi (132, 133) de la cavité (13), la deuxième paroi (132, 133) étant différente de la première paroi (131) et restant fixe lorsque la membrane déformable (12) se déforme.

11. Microsystème électromécanique (1) selon l'une quelconque des revendications précédentes, dans lequel la partie mobile (111a, 111b) de chaque transducteur électromécanique (11a, 11b)) présente une surface au moins deux fois supérieure à une surface de la zone libre (121) de la membrane déformable (12).

12. Système opto-électro-mécanique (3) comprenant au moins un microsystème électromécanique (1) selon l'une quelconque des revendications précédentes et au moins un microsystème optique (31).

13. Système opto-électro-mécanique (3) selon la revendication précédente, dans lequel ledit au moins un microsystème optique (31) comprend au moins un miroir, de préférence à base de silicium, le système opto-électro-mécanique (3) étant configuré de sorte à ce que le mouvement de la partie mobile (111a, 111b) de chacun desdits au moins deux transducteurs électromécaniques provoque un déplacement de l'au moins un miroir.

14. Procédé de fabrication d'un microsystème électromécanique (1) selon l'une quelconque des revendications 1 à 11, comprenant :
- une étape de formation, sur un substrat (200), d'une portion au moins d'au moins deux transducteurs électromécaniques (11a, 11b), puis
- une étape de dépôt de la membrane déformable (12), puis
- une étape de formation d'une cavité (13) ouverte sur la membrane déformable (12), puis
- une étape de remplissage avec le milieu déformable (14) et de fermeture de la cavité (12), et
- une étape de gravure du substrat (200) pour former une face avant (FAV) du microsystème électromécanique (1).

## Patentansprüche

1. Elektromechanisches Mikrosystem (1), das Folgendes umfasst:
- mindestens zwei elektromechanische Wandler (11a und 11b), die jeweils einen beweglichen Teil (111a, 111b) zwischen einer unbelasteten Gleichgewichtsposition und einer belasteten Nicht-Gleichgewichtsposition umfasst,
- mindestens eine verformbare Membran (12),
- einen verformbaren Hohlraum (13), der durch Wände (131, 132, 133) begrenzt ist, wobei mindestens ein Teil der verformbaren Membran (12) mindestens einen Teil einer ersten Wand (131) aus den Wänden (131, 132, 133) des Hohlraums (13) bildet, wobei der Hohlraum (13) hermetisch ein verformbares Medium (14) enthält, das unter der Einwirkung einer Änderung des Außendrucks, der durch eine der Wände (131, 132, 133) des Hohlraums (13) auf das verformbare Medium (14) ausgeübt wird, ein im Wesentlichen konstantes Volumen beibehält,
wobei der bewegliche Teil (111a, 111b) jedes elektromechanischen Wandlers (11a, 11b) derart konfiguriert ist, dass seine Bewegung von der Änderung des Außendrucks abhängt oder umgekehrt seine Bewegung eine Änderung des Außendrucks verursacht, und wobei der mindestens eine Teil der verformbaren Membran (12) mindestens eine freie Fläche (121) aufweist, die in Abhängigkeit von der Änderung des Außendrucks verformt wird,
wobei das elektromechanische Mikrosystem (1) ferner derart konfiguriert ist, dass:
die freie Fläche (121) dazu konfiguriert ist, mit mindestens einem äußeren Element (2) derart zusammenzuwirken, dass ihre Verformung eine Bewegung des äußeren Elements (2) verursacht oder durch diese verursacht wird, wobei die freie Fläche (121) der verformbaren Membran (12) dazu konfiguriert ist, über einen Stift (122), der an der freien Fläche (121) fixiert ist und vorzugsweise mit der freien Fläche (121) in Kontakt steht, mit dem äußeren Element (2) zusammenzuwirken,
der bewegliche Teil (111a) mindestens eines ersten elektromechanischen Wandlers (11a) derart konfiguriert ist, dass seine Belastung oder eine Erhöhung des Außendrucks seine Bewegung zur Außenseite des Hohlraums (13) hin verursacht, und
der bewegliche Teil (111b) mindestens eines zweiten elektromechanischen Wandlers (11b) derart konfiguriert ist, dass seine Belastung oder eine Verringerung des Außendrucks seine Bewegung zur Innenseite des Hohlraums (13) hin verursacht, und
wobei die mindestens zwei elektromechanischen Wandler (11a und 11b) sich auf einer gleichen Wand aus den Wänden (131, 132, 133) des Hohlraums (13) und in einem Abstand von der freien Fläche (121) der verformbaren Membran (12) erstrecken.

2. Elektromechanisches Mikrosystem (1) nach dem vorhergehenden Anspruch, wobei der mindestens eine erste elektromechanische Wandler (11a) mindestens einen ersten elektromechanischen Wandler umfasst, der die Form einer Scheibe mit dem Radius R1 aufweist, und der mindestens eine zweite elektromechanische Wandler (11b) mindestens einen zweiten elektromechanischen Wandler umfasst, der die Form eines Rings mit radialer Erstreckung R2 aufweist.

3. Elektromechanisches Mikrosystem (1) nach dem vorhergehenden Anspruch, wobei der mindestens eine erste elektromechanische Wandler (11a) und der mindestens eine zweite elektromechanische Wandler (11b) sich genau in eine kreisförmigen Fläche mit einem bestimmten Radius, der sogenannte "Gesamtradius", der als Rₜₒₜ bezeichnet wird, einfügt, wobei die kreisförmige Fläche aus zwei Teilen zusammengesetzt ist:
- einen ersten Teil, der die Form einer auf der kreisförmigen Fläche zentrierten Scheibe einnimmt, und
- einen zweiten Teil, der die Form eines Rings einnimmt, der sich um den ersten Teil erstreckt,
wobei der mindestens eine erste elektromechanische Wandler (11a) sich vor allem in den ersten Teil der kreisförmigen Fläche einfügt und der mindestens eine zweite elektromechanische Wandler (11b) sich vor allem in den zweiten Teil der kreisförmigen Fläche einfügt,
wobei der erste Teil der kreisförmigen Fläche einen Radius R_{2/3} aufweist, der im Wesentlichen zwei Drittel des Gesamtradius entspricht, und der zweite Teil der kreisförmigen Fläche eine radiale Erstreckung E_{1/3} aufweist, die im Wesentlichen einem Drittel des Gesamtradius entspricht.

4. Elektromechanisches Mikrosystem (1) nach dem vorhergehenden Anspruch, wobei der mindestens eine erste elektromechanische Wandler (11a) ferner mindestens einen ersten elektromechanischen Wandler (11c) mit der Form eines Rings umfasst, wobei sich jeder erste elektromechanische Wandler (11c) mit der Form eines Rings um den ersten elektromechanischen Wandler (11a) mit der Form einer Scheibe und gegebenenfalls um einen anderen ersten elektromechanischen Wandler mit der Form eines Rings erstreckt, und/oder der mindestens eine zweite elektromechanische Wandler (11b) eine Vielzahl von zweiten elektromechanischen Wandlern (11b, 11d) umfasst, die jeweils die Form eines Rings aufweisen und nebeneinander und konzentrisch zueinander angeordnet sind.

5. Elektromechanisches Mikrosystem (1) nach Anspruch 3, wobei der mindestens eine erste elektromechanische Wandler (11a) aus einem ersten elektromechanischen Wandler mit der Form einer Scheibe mit dem Radius R1 besteht und der mindestens eine zweite elektromechanische Wandler (11b) aus einem zweiten elektromechanischen Wandler mit der Form eines Rings mit radialer Erstreckung R2 umfasst.

6. Elektromechanisches Mikrosystem (1) nach dem vorhergehenden Anspruch, wobei die radiale Erstreckung R2 des durch den zweiten elektromechanischen Wandler (11b) gebildeten Rings etwa doppelt so klein ist wie der Radius R1 der durch den ersten elektromechanischen Wandler (11a) gebildeten Scheibe.

7. Elektromechanisches Mikrosystem (1) nach einem der beiden vorhergehenden Ansprüche, wobei der Radius R1 der durch den ersten elektromechanischen Wandler (11a) gebildeten Scheibe höchstens gleich 2/3 einer Summe Rₜₒₜ des Radius R1 der durch den ersten elektromechanischen Wandler (11a) gebildeten Scheibe und der radialen Erstreckung R2 des durch den zweiten elektromechanischen Wandler (11b) gebildeten Rings ist, und die radiale Erstreckung R2 des durch den zweiten elektromechanischen Wandler (11b) gebildeten Rings höchstens gleich 1/3 der Summe Rₜₒₜ des Radius R1 der durch den ersten elektromechanischen Wandler (11a) gebildeten Scheibe und der radialen Erstreckung R2 des durch den zweiten elektromechanischen Wandler (11b) gebildeten Rings ist.

8. Elektromechanisches Mikrosystem (1) nach einem der vorhergehenden Ansprüche, wobei die mindestens zwei elektromechanischen Wandler (11a und 11b) konzentrisch sind.

9. Elektromechanisches Mikrosystem (1) nach einem der vorhergehenden Ansprüche, wobei, mit mindestens einem Teil der mindestens zwei elektromechanischen Wandler (11a, 11b), der einen Teil der ersten Wand (131) des Hohlraums (13) bildet, der mindestens eine zweite elektromechanische Wandler (11b) derart konfiguriert ist, dass eine Bewegung seines beweglichen Teils (111b) von seiner Gleichgewichtsposition in seine Nicht-Gleichgewichtsposition eine Erhöhung des auf das verformbare Medium (14) wirkenden Außendrucks verursacht, und wobei die verformbare Membran (12) derart konfiguriert ist, dass eine Erhöhung des auf das verformbare Medium (14) wirkenden Außendrucks eine Verformung der freien Fläche (121) der verformbaren Membran (12) mit der Tendenz verursacht, diese von mindestens einer zweiten Wand (132, 133) des Hohlraums (13) wegzubewegen, wobei die zweite Wand (132, 133) sich von der ersten Wand (131) unterscheidet und fixiert bleibt, wenn die verformbare Membran (12) verformt wird.

10. Elektromechanisches Mikrosystem (1) nach einem der vorhergehenden Ansprüche, wobei der mindestens eine erste elektromechanische Wandler (11a) derart konfiguriert ist, dass eine Bewegung seines beweglichen Teils (111a) von seiner Gleichgewichtsposition in seine Nicht-Gleichgewichtsposition eine Verringerung des auf das verformbare Medium (14) wirkenden Außendrucks verursacht, und wobei die verformbare Membran (12) derart konfiguriert ist, dass eine Verringerung des auf das verformbare Medium (14) wirkenden Außendrucks eine Verformung der freien Fläche (121) der verformbaren Membran (12) mit der Tendenz verursacht, diese näher an mindestens eine zweite Wand (132, 133) des Hohlraums (13) zu bringen, wobei die zweite Wand (132, 133) sich von der ersten Wand (131) unterscheidet und fixiert bleibt, wenn die verformbare Membran (12) verformt wird.

11. Elektromechanisches Mikrosystem (1) nach einem der vorhergehenden Ansprüche, wobei der bewegliche Teil (111a, 111b) jedes elektromechanischen Wandlers (11a, 11b) eine Oberfläche aufweist, die mindestens doppelt so groß ist wie eine Oberfläche der freien Fläche (121) der verformbaren Membran (12).

12. Optoelektromechanisches System (3), das mindesten ein elektromechanisches Mikrosystem (1) nach einem der vorhergehenden Ansprüche und mindestens ein optisches Mikrosystem (31) umfasst.

13. Optoelektromechanisches System (3) nach dem vorhergehenden Anspruch, wobei das mindestens eine optische Mikrosystem (31) mindestens einen Spiegel, vorzugsweise auf Siliziumbasis, umfasst, wobei das optoelektromechanische System (3) derart konfiguriert ist, dass die Bewegung des beweglichen Teils (111a, 111b) jedes der mindestens zwei elektromechanischen Wandler eine Verschiebung des mindestens einen Spiegels bewirkt.

14. Verfahren zum Herstellen eines elektromechanischen Mikrosystems (1) nach einem der Ansprüche 1 bis 11, umfassend:
- einen Schritt des Bilden eines Abschnitts von mindestens zwei elektromechanischen Wandlern (11a, 11b) auf einem Substrat (200), dann
- einen Schritt des Abscheidens der verformbaren Membran (12), dann
- einen Schritt des Bildens eines offenen Hohlraums (13) auf der verformbaren Membran (12), dann
- einen Schritt des Befüllens des Hohlraums (12) mit dem verformbaren Medium (14) und des Schließens des Hohlraums, und
- einen Schritt des Ätzens des Substrats (200), um eine Vorderseite (FAV) des elektromechanischen Mikrosystems (1) zu bilden.

## Claims

1. An electromechanical microsystem (1) comprising:
- at least two electromechanical transducers (11a and 11b) each comprising a part (111a, 111b) moving between an equilibrium position, off-load, and an out-of-equilibrium position, under load,
- at least one deformable diaphragm (12),
- a deformable cavity (13), bounded by walls (131, 132, 133), at least part of the deformable diaphragm (12) forming at least part of a first wall (131) selected amongst said walls (131, 132, 133) of the cavity (13), the cavity (13) hermetically containing a deformable medium (14) maintaining a substantially constant volume under the action of a change in external pressure exerted on the deformable medium (14) through one of the walls (131, 132, 133) of the cavity (13),
wherein the moving part (111a, 111b) of each electromechanical transducer (11a, 11b) is configured such that its movement depends on said change in external pressure, or conversely such that its movement causes a change in external pressure, and wherein said at least one part of the deformable diaphragm (12) is provided with at least one area (121) free to deform, depending on said change in external pressure,
the electromechanical microsystem (1) being further such that:
the free area (121) being configured to cooperate with at least one external member (2) so that its deformation causes, or is caused by, a movement of the external member (2), the free area (121) of the deformable diaphragm (12) is configured to cooperate with the external member (2) via a pin (122) attached to said free area (121), preferably in contact with said free area (121),
the moving part (111a) of at least a first electromechanical transducer (11a) is configured so that acting upon it or an increase in external pressure causes its movement towards the outside of the cavity (13), and
the moving part (111b) of at least a second electromechanical transducer (11b) is configured so that acting upon it or a decrease in external pressure causes its movement towards the inside of the cavity (13), and
wherein said at least two electromechanical transducers (11a and 11b) extend on the same wall chosen from the walls (131, 132, 133) of the cavity (13) and at a distance from the free area (121) of the deformable diaphragm (12).

2. The electromechanical microsystem (1) according to the preceding claim, wherein said at least one first electromechanical transducer (11a) comprises at least one first disc-shaped electromechanical transducer of radius R1 and said at least one second electromechanical transducer (11b) comprises at least one second ring-shaped electromechanical transducer with a radial extension R2.

3. The electromechanical microsystem (1) according to the preceding claim, wherein said at least one first electromechanical transducer (11a) and said at least one second electromechanical transducer (11b) are contained within the boundaries of a circular area of given radius, known as the "total radius" and noted Rₜₒₜ, with said circular area being consisting of two parts:
- a first part is shaped like a disc centred on said circular area and
- a second part is shaped like a ring extending around the first part,
said at least one first electromechanical transducer (11a) is contained more particularly within the first part of the circular area and said at least one second electromechanical transducer (11b) is contained more particularly within the second part of the circular area, the first part of the circular area has a radius R_{2/3} substantially equal to two thirds of the total radius and the second part of the circular area has a radial extension E_{1/3} substantially equal to one third of the total radius.

4. The electromechanical microsystem (1) according to the preceding claim, wherein said at least one first electromechanical transducer (11a) further comprises at least one first ring-shaped electromechanical transducer (11c), each first ring-shaped electromechanical transducer (11c) extending around the first disc-shaped electromechanical transducer (11a) and if applicable around another first ring-shaped electromechanical transducer and/or said at least one second electromechanical transducer (11b) comprises a plurality of second electromechanical transducers (11b, 11d) each ring shaped and being arranged adjacent to and concentric with each other.

5. The electromechanical microsystem (1) according to claim 3, wherein said at least one first electromechanical transducer (11a) consists of one first disc-shaped electromechanical transducer of radius R1 and said at least one second electromechanical transducer (11b) consists of a second ring-shaped electromechanical transducer with a radial extension R2.

6. The electromechanical microsystem (1) according to the preceding claim, wherein the radial extension R2 of the ring formed by the second electromechanical transducer (11b) is about twice as small as the radius R1 of the disc formed by the first electromechanical transducer (11a).

7. The electromechanical microsystem (1) according to any one of the two preceding claims, wherein the radius R1 of the disc formed by the first electromechanical transducer (11a) is at most equal to 2/3 of the sum Rₜₒₜ of the radius R1 of the disc formed by the first electromechanical transducer (11a) and of the radial extension R2 of the ring formed by the second electromechanical transducer (11b), and the radial extension R2 of the ring formed by the second electromechanical transducer (11b) is at most equal to 1/3 of the sum Rₜₒₜ of the radius R1 of the disc formed by the first electromechanical transducer (11a) and the radial extension R2 of the ring formed by the second electromechanical transducer (11b).

8. The electromechanical microsystem (1) according to any one of the preceding claims, wherein said at least two electromechanical transducers (11a and 11b) are concentric.

9. The electromechanical microsystem (1) according to any one of the preceding claims, wherein, with at least a part of said at least two electromechanical transducers (11a, 11b) forming part of said first wall (131) of the cavity (13), said at least a second electromechanical transducer (11b) is configured such that a movement of its moving part (111b) from its equilibrium position to its out-of-equilibrium position causes an increase in the external pressure acting on the deformable medium (14) and wherein the deformable diaphragm (12) is configured such that an increase in the external pressure acting on the deformable medium (14) causes a deformation of the free area (121) of the deformable diaphragm (12) tending to move it away from at least a second wall (132, 133) of the cavity (13), with the second wall (132, 133) being different from the first wall (131) and remaining fixed when the deformable diaphragm (12) is deformed.

10. The electromechanical microsystem (1) according to any one of the preceding claims, wherein said at least one first electromechanical transducer (11a) is configured such that a movement of its moving part (111a) from its equilibrium position to its out-of-equilibrium position causes a decrease in the external pressure acting on the deformable medium (14) and wherein the deformable diaphragm (12) is configured such that a decrease in the external pressure acting on the deformable medium (14) causes a deformation of the free area (121) of the deformable diaphragm (12) tending to move it towards at least a second wall (132, 133) of the cavity (13), with the second wall (132, 133) being different from the first wall (131) and remaining fixed when the deformable diaphragm (12) is deformed.

11. The electromechanical microsystem (1) according to any one of the preceding claims, wherein the moving part (111a, 111b) of each electromechanical transducer (11a, 11b) has a surface area at least twice that of a surface area of the free area (121) of the deformable diaphragm (12).

12. An opto-electro-mechanical system (3) comprising at least one electromechanical microsystem (1) according to any one of the preceding claims and at least one optical microsystem (31).

13. The opto-electro-mechanical system (3) according to the preceding claim, wherein said at least one optical microsystem (31) comprises at least one, preferably silicon-based mirror, the opto-electro-mechanical system (3) being configured such that the movement of the moving part (111a, 111b) of each of said at least two electromechanical transducers causes a movement of the at least one mirror.

14. A process of manufacturing an electromechanical microsystem (1) according to any one of claims 1 to 11, comprising:
- a step involving the forming, on a substrate (200), of at least a portion of at least two electromechanical transducers (11a, 11b), then
- a step involving the deposition of the deformable diaphragm (12), then
- a step involving the forming of an open cavity (13) on the deformable diaphragm (12), then
- a step involving the filling with the deformable medium (14) and the closing of the cavity (12), and
- a step involving the etching of the substrate (200) to form a front face (FAV) of the electromechanical microsystem (1).
